(19) Europäisches Patentamt / European Patent Office / Office européen des brevets

(11) **EP 4 475 655 B1**

(12) **EUROPEAN PATENT SPECIFICATION**

(45) Date of publication and mention
of the grant of the patent:
**24.12.2025 Bulletin 2025/52**

(51) International Patent Classification (IPC):
***H10N 60/01*** (2023.01)   ***H10N 60/20*** (2023.01)
***H10N 60/80*** (2023.01)

(21) Application number: **23177401.9**

(22) Date of filing: **05.06.2023**

(52) Cooperative Patent Classification (CPC):
**H10N 60/0548; H10N 60/0324; H10N 60/0801;
H10N 60/203; H10N 60/80**

(54) **METHOD FOR PRODUCING A SUPERCONDUCTING JOINT OF REBCO TAPES BY USE OF A BRIDGE TAPE ELEMENT, A SUPERCONDUCTING JOINT AND USE OF A SUPERCONDUCTING JOINT**

VERFAHREN ZUR HERSTELLUNG EINER SUPRALEITENDEN VERBINDUNG VON REBCO-BÄNDERN DURCH VERWENDUNG EINES BRÜCKENBANDELEMENTS, EINE SUPRALEITENDE VERBINDUNG UND VERWENDUNG EINER SUPRALEITENDEN VERBINDUNG

PROCÉDÉ DE FABRICATION D'UN JOINT SUPRACONDUCTEUR DE RUBANS EN REBCO EN UTILISANT UN ÉLÉMENT DE RUBAN À FONCTION DE PONT, JOINT SUPRACONDUCTEUR ET UTILISATION D'UN JOINT SUPRACONDUCTEUR

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**11.12.2024 Bulletin 2024/50**

(73) Proprietor: **Bruker Switzerland AG**
**8117 Fällanden (CH)**

(72) Inventors:
• **CAYADO, Pablo**
 **74100 Ambilly (FR)**
• **SENATORE, Carmine**
 **1205 Genève (CH)**
• **KONSTANTOPOULOU, Konstantina**
 **1004 Lausanne (CH)**
• **MARCH, Stephen Alfred**
 **8048 Zürich (CH)**

(74) Representative: **Kohler Schmid Möbus
Patentanwälte
Partnerschaftsgesellschaft mbB
Gropiusplatz 10
70563 Stuttgart (DE)**

• **KATAYAMA S ET AL:** "Highly oriented YBa2Cu4O8 films fabricated at atmospheric pressure by the sol-gel method using metal alkoxides", APPLIED PHYSICS LETTERS, AMERICAN INSTITUTE OF PHYSICS, 2 HUNTINGTON QUADRANGLE, MELVILLE, NY 11747, vol. 60, no. 1, 6 January 1992 (1992-01-06), pages 118 - 119, XP000257147, ISSN: 0003-6951, DOI: 10.1063/1.107366
• **MASUDA Y ET AL:** "Production of YBa2Cu3O7-x thick films on Ag metal substrate controlled by oxygen", JAPANESE JOURNAL OF APPLIED PHYSICS, JAPAN SOCIETY OF APPLIED PHYSICS, JP, vol. 31, no. 9A, 1 September 1992 (1992-09-01), pages 2709 - 2715, XP000355742, ISSN: 0021-4922, DOI: 10.1143/JJAP.31.2709
• **LIU M ET AL:** "Fabrication of YBCO Films on and Textured Ag Substrates by TFA-MOD Method", IEEE TRANSACTIONS ON APPLIED SUPERCONDUCTIVITY, IEEE, USA, vol. 17, no. 2, 1 June 2007 (2007-06-01), pages 3601 - 3604, XP011188922, ISSN: 1051-8223, DOI: 10.1109/TASC.2007.898339

(56) References cited:
**GB-A- 2 565 839    JP-A- 2021 068 583**

EP 4 475 655 B1

- AMEMIYA I ET AL: "Preparation of Y-Ba-Cu-O superconducting tape by pyrolysis of organic acid salts", vol. 27, no. 2, 1 March 1991 (1991-03-01), USA, pages 905 - 908, XP093105288, ISSN: 0018-9464, Retrieved from the Internet <URL:https://ieeexplore.ieee.org/stampPDF/getPDF.jsp?tp=&arnumber=133322&ref=aHR0cHM6Ly9pZWVleHBsb3JlLmllZWUub3JnL2RvY3VtZW50LzEzMzMyMg==> DOI: 10.1109/20.133322
- HUANG D ET AL: "Achievement of Low-Resistivity Diffusion Joint of REBCO Coated Conductors by Improving the Interface Connection of Ag Stabilizer", IEEE TRANSACTIONS ON APPLIED SUPERCONDUCTIVITY, IEEE, USA, vol. 31, no. 3, 8 January 2021 (2021-01-08), pages 1 - 7, XP011835039, ISSN: 1051-8223, [retrieved on 20210130], DOI: 10.1109/TASC.2021.3050336
- OBRADORS X ET AL: "Progress towards all-chemical superconducting YBa2Cu3O7-coated conductors", SUPERCONDUCTOR SCIENCE AND TECHNOLOGY, IOP PUBLISHING, TECHNO HOUSE, BRISTOL, GB, vol. 19, no. 3, 20 January 2006 (2006-01-20), pages S13 - S26, XP020100846, ISSN: 0953-2048, DOI: 10.1088/0953-2048/19/3/003

## Description

The invention relates to a method for producing a superconducting joint of REBCO tapes by use of a bridge tape element.

Such a method is known from GB 2 565 839 A.

High temperature superconductor (HTS) materials, such as REBCO (=rare earth barium copper oxide), can be used to manufacture high field superconducting magnets, which are for example used in NMR (=nuclear magnetic resonance) systems, such as NMR spectrometers or MRI (=magnetic resonance imaging) tomographs. REBCO material is typically used in tapes, wherein a substrate, typically a stainless steel or Hastelloy substrate, is covered with a REBCO layer. The tapes may be wound in coils, in particular solenoid coils, in order to form a magnet.

REBCO tapes can only be manufactured with a limited length. Therefore, in order to wind a complete superconducting magnet, often multiple REBCO tapes have to be connected in a superconducting way ("joint"). However, manufacturing joints of REBCO tapes is a challenging task, in particular if the REBCO tapes are intended for a superconducting magnet to be operated in persistent mode. The joint should have a high quality, i.e. it should have a low ohmic resistance, and at the same time it should be easy to manufacture.

An overview of joints for superconducting tapes or wires is given in GB 2 565 839 A. In a so called "lap joint", two superconducting elements are overlapped in an end region with their superconducting layers exposed. In so called "indirect joints", two superconducting elements are connected via an intermediate superconducting element, which may include solder, powder, or tape bridge pieces.

A particular difficulty with REBCO tapes is that after bonding two REBCO layers, it is generally required to perform reoxygenation (also called annealing). However, substrate materials such as stainless steel and Hastelloy allow only a rather slow oxygen diffusion through it, so reoxygenation takes rather long.

EP 2 741 370 A1 suggests a joint of REBCO coated conductors, wherein the stabilizing layers are removed by etching, the surfaces of the HTS layers are brought into direct contact, then heating in a splicing furnace is done to permit interdiffusion of REBCO atoms, and then an oxygenation annealing is done. In order to improve oxygen diffusion during the oxygenation annealing, it is suggested to provide micro-holes in the substrates of the REBCO coated conductors. However, drilling the micro-holes is difficult and expensive.

GB 2 565 839 A suggests to exfoliate a REBCO layer from the substrate of a conventional REBCO tape, wherein the exfoliated REBCO layer is fixed to an oxygen permeable backing lamination, for example made of silver. This structure can be used as a bridge between two REBCO tapes having an exposed REBCO layer.

However, the exfoliation process and further handling of the exfoliated REBCO layer are rather difficult.

US 10,333,050 B discloses a method for producing a REBCO tape wherein a REBCO layer is deposited on a substrate by a chemical solution deposition process.

In KATAYAMA S ET AL: "Highly oriented YBa2-Cu4O8 films fabricated at atmospheric pressure by the sol-gel method using metal alkoxides", APPLIED PHYSICS LETTERS, vol. 60, no. 1, pages 118-119, 6 January 1992, the authors describe the fabrication of films of the high temperature superconductor $YBa_2Cu_4O_8$ (=yttrium barium copper oxide) on a silver substrate from a heterometallic alkoxide solution. The solution is deposited on the silver substrate via dip-coating. The coated substrate is subsequently heated in air. In order to increase film thickness, this process can be repeated several times. Through further heating under argon, remaining organic compounds are removed and after firing in flowing oxygen, films of highly oriented $YBa_2Cu_4O_8$ are obtained.

MASUDA Y ET AL: "Production of YBa2Cu3O7-x thick films on Ag metal substrate controlled by oxygen", JAPANESE JOURNAL OF APPLIED PHYSICS, vol. 31, no. 9A, pages 2709-2715, 1 September 1992, describes the formation of superconducting thick films on silver substrates. The process includes spraying a prepared sol onto the respective substrate, obtaining a precursor film by heating, and subsequently calcining the precursor film in air in order to obtain a calcined film. By repeating those steps, film thickness is increased. Thereafter, a carefully tuned firing and annealing process at varying temperatures and oxygen concentration levels is employed in order to obtain a superconducting film with favourable properties.

In LIU M ET AL: "Fabrication of YBCO Films on and Textured Ag Substrates by TFA-MOD Method", IEEE TRANSACTIONS ON APPLIED SUPERCONDUCTIVITY, vol. 17, no. 2, pages 3601-3604, 1 June 2007, superconducting YBCO (=yttrium barium copper oxide) films are obtained by spin-coating a textured silver substrate with a trifluoroacetic acid precursor solution, followed by the removal of water and acetic and a subsequent two-stage heat treatment. In the first stage, an amorphous precursor film is obtained by slow heating in humid oxygen atmosphere. The second stage includes firing in humid argon atmosphere and is followed by a slow cooling process. The firing temperature is adapted in order to obtain a high-quality textured YBCO film.

OBRADORS X ET AL: "Progress towards all-chemical superconducting YBa2Cu3O7-coated conductors", SUPERCONDUCTOR SCIENCE AND TECHNOLOGY, vol. 19, no. 3, pages S13-S26, 20 January 2006, describes a comparable method. A detailed investigation into processes involved in obtaining high-quality YBCO coated conductors, while shortening pyrolysis time and increasing single-deposition film thickness, is presented. Among other things, the authors state that high-quality films can be obtained by pyrolysis of anhydrous TFA (trifluoroacetate) -YBCO precursors under flowing oxygen.

AMEMIYA I ET AL: "Preparation of Y-Ba-Cu-O superconducting tape by pyrolysis of organic acid salts", IEEE TRANSCACTIONS ON MAGNETICS, vol. 27, no. 2, pages 905-908, 1 March 1991, describes the formation of YBCO films with a ratio of the metals of 1:2:4 on silver substrate at atmospheric pressure. A solution containing organo-metal compounds and an organic solvent is applied to the silver substrate and pyrolysed in order to form an amorphous calcined layer. The thickness of this layer can be increased by repeating the application and calcination steps. With a subsequent heat treatment, a superconducting tape is obtained.

HUANG D ET AL: "Achievement of Low-Resistivity Diffusion Joint of REBCO Coated Conductors by Improving the Interface Connection of Ag Stabilizer", IEEE TRANSACTIONS ON APPLIED SUPERCONDUCTIVITY vol. 31, no. 3, 8 January 2021, describes the fabrication of a bridge-type joint of superconducting REBCO tapes. Stabilizing silver layers of the coated conductor tapes to be joined and the bridging element are bonded through a diffusion bonding process. Etched microchannels in the stabilizing silver layer of the bridging element serve as fast oxygen diffusion paths for reducing oxygenation annealing time. Additionally, a process of peeling off a REBCO layer from a coated conductor tape after diffusion bonding with a silver tape is described. The REBCO layer obtained by peeling can be applied to fabricate the superconducting joint. A further example of prior art is JP2021068583A, which describes a bridge-type joint of superconducting REBCO tapes, comprising a REBCO layer deposited by a chemical solution deposition process.

Object of the invention

It is the object of the present invention to allow for a superconducting joint of REBCO tapes with a high quality that is easy to manufacture.

Short description of the invention

This object is achieved by a method for producing a superconducting joint of REBCO tapes, with the following steps:

Step a) at a first REBCO base tape, comprising at least a base metal substrate, a base REBCO layer located on the base metal substrate, and a stabilizing layer located on the base REBCO layer, the stabilizing layer is removed in a first end region; and at a second REBCO base tape, comprising at least a base metal substrate, a base REBCO layer located on the base metal substrate, and a stabilizing layer located on the base REBCO layer, the stabilizing layer is removed in a second end region; and a bridge tape element is produced by deposition of a REBCO layer by a chemical solution deposition

(=CSD) process on a substrate being a silver substrate, wherein the silver substrate is made of silver or a silver alloy containing at least 75 weight% of silver, wherein
the CSD process includes

- at least one deposition step, wherein a REBCO precursor solution is deposited on the silver substrate, resulting in a gel-like REBCO precursor layer, with the REBCO precursor solution comprising a solvent and dissolved REBCO precursor salts including organic content,

and with the gel-like REBCO precursor layer containing an amorphous mixture of REBCO components including organic content,

- at least one pyrolysis step, wherein a gel-like REBCO precursor layer is pyrolysed in a first stage heat treatment, resulting in an amorphous REBCO component layer,

with the amorphous REBCO component layer containing an amorphous mixture of REBCO components and being devoid of organic content;

- at least one transformation step, wherein at least one amorphous REBCO component layer is transformed in a second stage heat treatment, resulting in a REBCO material layer,

with the REBCO material layer containing polycrystalline or textured REBCO; Step a') respective auxiliary REBCO layers are deposited by a further CSD process on the base REBCO layers of the first REBCO base tape in the first end region and of the second REBCO base tape in the second end region; Step b) the first REBCO base tape, the second REBCO base tape and the bridge tape element are arranged such that in the first end region, the bridge tape element overlaps with and contacts the first REBCO base tape, and in the second end region, the bridge tape element overlaps with and contacts the second REBCO base tape, with the REBCO layer of the bridge tape element and the base REBCO layers of the first REBCO base tape and the second REBCO base tape facing each other; Step c) in the first end region and in the second end region, the first REBCO base tape, the second REBCO base tape and the bridge tape element are pressed together with a mechanical pressure $p_{bond}$ during a heat treatment at a temperature $Temp_{bond}$ below the melting temperature of the silver substrate in a low oxygen atmosphere with an oxygen partial pressure $OPP_{bond}$ during a bonding time $t_{bond}$; Step d) in the first end region and in the second end region, the first REBCO base tape, the second REBCO base tape and the bridge tape element undergo a heat treatment at a temperature $Temp_{anneal}$, with $Temp_{anneal} < Temp_{bond}$, in a high oxygen atmosphere with an oxygen partial pressure $OPP_{anneal}$, with $OPP_{anneal} > OPP_{bond}$, during an annealing time $t_{anneal}$, with $t_{anneal} \geq t_{bond}$,

in particular wherein in step d) no mechanical pressure is applied any more.

One aspect of the present invention is to manufacture a bridge tape element for a superconducting joint by means of depositing a REBCO layer on a silver substrate by a CSD process.

By using a silver substrate, the bridge tape element is well suited for an annealing/reoxygenation step in joint manufacturing, in order to restore good superconducting electric conductivity after bonding the REBCO layer of the bridge tape element to the REBCO layers of REBCO tapes to be connected (the latter are also referred to first and second REBCO base tapes, and their REBCO layers are also referred to as base REBCO layers here). Diffusion of oxygen can occur comparably quickly through the silver substrate, as compared to a stainless steel substrate or Hastelloy substrate. Accordingly, the annealing/reoxygenation step can be done in a short time, in particular 10 hours or less, and often 2 hours or less. Further, a silver substrate is easy to provide.

Further, the CSD process is comparably simple to perform, and leads to REBCO layers of good or even very high quality on silver substrates. Further, by using multiple deposition steps, the final thickness of the REBCO layer may be adjusted in a simple way. In particular, also relatively thick REBCO layers may be produced, with a corresponding high superconducting current carrying capacity of the final joint.

Depositing the REBCO layer on the silver substrate by CSD in particular is much easier than exfoliating REBCO layers from a conventional REBCO tape, and also much easier than drilling holes in a REBCO tape substrate (or REBCO bridge tape element substrate). Further, the CSD process on the silver substrate is easy to perform on an industrial scale, in contrast to the exfoliation approach or the drilling approach.

It should be noted that in order to achieve a typical desired REBCO layer thickness in the final bridge tape element, preferably at least two deposition steps (each followed by a pyrolysis step) are used. However, note that for some applications, it may be enough to have only a single deposition step (and a single pyrolysis step) in the CSD process. The final step of the CSD process is generally a transformation step. The REBCO material layers of all transformation steps together make the final REBCO layer of the bridge tape element.

The bridge tape element produced is used in the inventive method for producing a superconducting joint of REBCO tapes.

With step a) (preparation), step b) (arrangement), step c) (bonding) and step d) (annealing/reoxygenation), a superconducting joint linking two REBCO tapes (i.e. the first and second REBCO base tape) by means of a bridge tape element can be produced with good or even very high quality and in an easy way. In particular, production does not require delicate handling of exfoliated REBCO layers or drilling of micro-holes in substrates, and is relatively fast, since annealing/reoxygenation benefits from fast oxygen diffusion through the silver substrate of the bridge tape element. So the inventive method is well suited for industrial scale. Good or even very high joint quality can be achieved, such that superconducting magnets containing REBCO tapes including the joints produced as described above can be run in persistent mode at very low losses.

In a step a') performed between steps a) and b), respective auxiliary REBCO layers are deposited by a CSD process on the base REBCO layers of the first REBCO base tape in the first end region and of the second REBCO base tape in the second end region. Note that the auxiliary REBCO layers of step a') may be produced in analogy to the production of a REBCO layer of the bridge tape element, in particular including one or a plurality of pyrolysis subsequences, and one or a plurality of transformation subsequences. The auxiliary REBCO layers may improve the superconducting current carrying capacity of the joint.

Note that before or during step b), the first and second REBCO base tape may be mechanically joined together, e.g. by clamping on a common support. During bonding in step c), there typically occurs bonding without re-texturing (or partial re-melting) of the REBCO material in the first and second end region in the REBCO base tapes and in the bridge tape element if the REBCO layer of the bridge tape element was initially textured. Alternatively, during the bonding step c), there typically occurs bonding with re-texturing of the REBCO material of the REBCO layer of the bridge tape element if the REBCO layer of the bridge tape element was initially polycrystalline. Note that $Temp_{bond}$ and $t_{bond}$ (and possibly also $OPP_{bond}$) are chosen depending on whether or not re-texturing is done. The annealing/reoxygenation in step d) can be kept comparably short, since the silver substrate allows fast oxygen diffusion through it, so oxygen can easily reach the REBCO material in the first and second end region.

Typically, in the arrangement of step b), the REBCO layer of the bridge tape element and the auxiliary REBCO layers of the first and second REBCO base tapes are in direct contact with each other in the first and second end region.

Preferred variants of the invention

In a preferred variant of the inventive method, the CSD process of step a) and/or the further CSD process of step a') include(s) a plurality of pyrolysis subsequences, wherein each pyrolysis subsequence includes a deposition step followed by a pyrolysis step. In this way, the thickness of the final REBCO layer and/or the auxiliary REBCO layers may be increased in an easy way. Alternatively, the CSD process and/or the further CSD process may include only a single pyrolysis subsequence (in other words, then in total the method comprises a single deposition step, followed by a single pyrolysis step, followed by a single transformation step), what is particularly quick to do, but allows only a limited REBCO layer thickness.

In a preferred further development of the above variant, the CSD process of step a) and/or the further CSD process of step a') include(s) performing a plurality of subsequent pyrolysis subsequences before performing a next transformation step. In this way, multiple amorphous REBCO component sublayers may be stacked up, and transformed in common with the next transformation step. This allows a particularly quick processing when thicker REBCO layers are desired.

In a preferred subvariant of the above further development, the CSD process of step a) and/or the further CSD process of step a') include(s) performing a common transformation step, wherein all amorphous REBCO component layers obtained in all pyrolysis steps are transformed in common. In other words, only one final transformation step is done in the CSD process and/or the further CSD process, during which the amorphous REBCO component layer(s) of the previous pyrolysis step(s) are transformed/crystallized. This allows a particularly quick processing, and avoids interlayer boundaries within the final REBCO layer(s).

Another further development of the above variant provides that the CSD process of step a) and/or the further CSD process of step a') include(s) a plurality of subsequent transformation subsequences, wherein each transformation subsequence includes at least one pyrolysis subsequence followed by a transformation step. In this further development, transformation of amorphous REBCO component layers is distributed over a plurality of transformation subsequences. In this way, an even thicker final REBCO layer and/or even thicker auxiliary REBCO layers may be achieved with high crystalline quality. This further development can in particular be used when a rather high number of pyrolysis subsequences, such as 6 or more pyrolysis subsequences, are required to build up the desired REBCO layer(s). Typically, each transformation subsequence comprises 5 or less, preferably 4 or less, highly preferable 3 or less, pyrolysis subsequences.

In a preferred subvariant of this further development, at least one transformation subsequence, preferably each transformation subsequence, comprises only one pyrolysis subsequence. In this way, the crystalline quality of the REBCO material layers can often be further improved.

In another subvariant of the above further development, at least one transformation subsequence, preferably each transformation subsequence, comprises a plurality of subsequent pyrolysis subsequences. This again can provide a quick processing when a large thickness of the final REBCO layer and/or the auxiliary REBCO layers is desired.

In a preferred variant of the inventive method, at least one first stage heat treatment, in particular each first stage heat treatment, includes a dwell at a temperature $Temp_{pyro}$, with 300°C$\leq Temp_{pyro}\leq$550 °C for a pyrolysis time $t_{pyro}$, with 10 min$\leq t_{pyro}\leq$60 min. This has shown good results in practice for generating the amorphous REBCO component layer(s).

Further preferred is a variant wherein at least one second stage heat treatment, in particular each second stage heat treatment, includes a dwell at a temperature $Temp_{trans}$, with between 750°C$\leq Temp_{trans}\leq$850 °C for a crystallization time $t_{trans}$, with 5 min$\leq t_{trans}\leq$180 min. This has shown good results in practice for generating a REBCO material layer containing polycrystalline or textured REBCO on the silver substrate of the bridge tape element.

Further preferred is a variant wherein at least one first stage heat treatment, in particular each first stage heat treatment, is done in pure oxygen atmosphere.

This facilitates burning out the organic content contained in the gel-like REBCO precursor layer(s) in the pyrolysis step. Note that alternatively, also an atmosphere with a somewhat lower oxygen content may be used (such as with an oxygen partial pressure of at least 0.5 bar), what might prolong the first heat treatment though.

In an advantageous variant, at least one second stage heat treatment, in particular each second stage heat treatment, is done in an atmosphere with an oxygen partial pressure with a corresponding oxygen concentration of 10-1000 ppm. With such an atmosphere, formation of a REBCO material layer containing textured REBCO material can be facilitated.

Further advantageous is a variant wherein at least one second stage heat treatment, in particular each second stage heat treatment, is done in pure oxygen atmosphere. With such an atmosphere, formation of a REBCO material layer containing polycrystalline REBCO material can be facilitated. Note that in order to obtain a polycrystalline REBCO material layer during transformation, an oxygen partial pressure of at least 0.5 bar is preferred.

Preferred is also a variant wherein the REBCO layer is deposited directly on the silver substrate. In other words, in the first deposition step of the CSD process, the REBCO precursor solution is applied directly on the silver substrate, with no buffer layers on the silver substrate. This is particularly inexpensive. This variant is often chosen if a REBCO material layer containing polycrystalline REBCO is desired, typically with a silver substrate of non-textured silver material. However, even in this variant, a functionally "textured substrate" can be obtained by choosing a silver substrate of textured silver material, so a textured REBCO material can be obtained after the transformation step.

In another preferred variant, the silver substrate is provided with one or more buffer layers, and the REBCO layer is deposited on top of the one or more buffer layers of the silver substrate. In other words, in the first deposition step of the CSD process, the REBCO precursor solution is applied on top of the one or more buffer layers located on the silver substrate. One or more buffer layers can provide a functionally "textured substrate", on which a textured REBCO material can be obtained after the transformation step, even if the silver material of the silver substrate is not textured.

In a preferred variant, the silver substrate is chosen as a textured silver substrate, in particular with the silver substrate exposing a surface in a 001 or 110 orientation to the REBCO layer. A silver substrate of textured silver material can provide a functionally "textured substrate", on which a textured REBCO material can be obtained after the transformation step, even if no buffer layers are used.

In another preferred variant, the silver substrate is chosen as a non-textured polycrystalline silver substrate. A non-textured polycrystalline silver substrate is particularly inexpensive, and can in particular be used when a polycrystalline REBCO material is desired after the transformation step. However, even in this situation, a functionally "textured substrate" can be obtained by applying one or more buffer layers on the polycrystalline silver material, and then a textured REBCO material can still be obtained after the transformation step.

In an advantageous variant, the silver substrate is chosen with a thickness $TH_{sub}$, with $25\mu m \leq TH_{sub} \leq 2.5mm$. This thickness range has shown good results in practice, with respect to both sufficient mechanical stability and sufficient transfer of oxygen through it in an annealing/reoxygenation step in joint production. Note that a $TH_{sub}$ of $100\mu m$ or more, preferably $250\,\mu m$ or more, is particularly preferred for a good mechanical stability. Further, thickness $TH_{sub}$ may be chosen with $TH_{sub} \leq 1mm$, in order to facilitate oxygen diffusion through the silver substrate or accelerate it, respectively, and to allow particularly fast production. In particular, with a low thickness $TH_{sub}$, time for annealing/reoxygenation will be determined above all by the REBCO layer itself, and not by the silver substrate.

Further preferred is a variant wherein the REBCO layer is deposited on the silver substrate with a thickness $TH_{inter}$, with $500nm \leq TH_{inter}$, in particular with $1\mu m \leq TH inter \leq 5\mu m$. The thickness $TH_{inter}$ here relates to the final thickness of the REBCO layer of the bridge tape element after the last transformation step. With such a thickness $TH_{inter}$, a good superconducting current carrying capacity of the bridge tape element or the resulting joint, respectively, can be achieved.

A preferred variant of the above method provides that during step c),

$$5\ MPa \leq p_{bond} \leq 50\ Mpa,$$

and/or $750°C \leq Temp_{bond} \leq 900°C$,
and/or the oxygen partial pressure $OPP_{bond}$ has a corresponding oxygen concentration of 10-1000 ppm,
and/or $1\ min \leq t_{bond} \leq 60\ min$,
and/or that during step d),
$300°C \leq Temp_{anneal} \leq 600°C$,
and/or $0.5\ bar \leq OPP_{anneal}$,
in particular wherein a pure oxygen atmosphere is applied,
and/or $0h \leq t_{anneal} \leq 10h$.

These parameters have shown good results in practice from producing the joint.

*Joints and uses according to the invention*

Also within the scope of the present invention is a superconducting joint of REBCO tapes,

with the superconducting joint comprising a first REBCO base tape having a first end region, a second REBCO base tape having a second end region, and a bridge tape element, with the bridge tape element comprising a substrate and a REBCO layer located on the substrate,
wherein the REBCO layer is a REBCO layer deposited by a chemical solution deposition, CSD, process on the substrate being a silver substrate, wherein the silver substrate is made of silver or a silver alloy containing at least 75 weight% of silver, with the first REBCO base tape and the second REBCO base tape each comprising at least a base metal substrate, a base REBCO layer located on the base metal substrate, and a stabilizing layer located on the base REBCO layer,
wherein in the first end region and the second end region, the first REBCO tape and the second REBCO tape are devoid of the stabilizing layer,
and wherein auxiliary REBCO layers are deposited by a further CSD process on the base REBCO layer in
the first end region and the second end region,
and wherein in the first end region the bridge tape element overlaps with the first REBCO base tape, and in the second end region the bridge tape element overlaps with the second REBCO base tape, with the REBCO layer of the bridge tape element and the base REBCO layers of the first REBCO base tape and the second REBCO base tape facing each other and being connected to each other, where the auxiliary REBCO layers on the one hand, and the REBCO layer of the bridge tape element on the other hand, are facing each other and contacting each other,

in particular wherein the superconducting joint of REBCO tapes is produced by a method according to the invention as described above. The inventive joint can be produced easily and in particular relatively fast, since the silver substrate of the bridge tape element allows a fast oxygen diffusion through it during annealing/reoxygenation.

The base metal substrates of the REBCO base tapes are typically made of stainless steel or Hastelloy (or other Ni-based alloys), and typically are practically impermeable for oxygen diffusion. It should be noted that the base REBCO layers on the one hand, and the REBCO layer of the bridge tape element on the other hand, may be made of different REBCO materials or of identical REBCO materials, as desired.

According to the invention, an auxiliary REBCO layer has been deposited by a CSD process on the base REBCO layers of the first and second REBCO base tapes in the first and second end regions, the REBCO layer of the bridge tape element and the base REBCO layers of the first and second REBCO base tape are connected to each other via the respective auxiliary REBCO layers.

Also within the scope of the present invention is a use of a superconducting joint of REBCO tapes according to the invention as described above or produced according to a method according to the invention as described above, in a superconducting magnet of an NMR spectrometer or MRI tomograph, in particular wherein the superconducting magnet is operated in persistent mode. The inventive joints or joints produced according to the invention may achieve a good or even very high quality, in particular well suited for persistent mode operation in magnetic resonance applications. The production of the joints is easy and fast, and in particular well suited for industrial scale.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention. The invention is defined by the appended claims.

Detailed description of the invention and drawing

Fig. 1     shows a schematic flow diagram of a part of the inventive method for producing a bridge tape element for a superconducting joint of REBCO tapes;

Fig. 2     shows a variant of the method of Fig. 1, comprising only one transformation subsequence which in turn comprises only one pyrolysis subsequence;

Fig. 3     shows a variant of the method of Fig. 1, comprising only one transformation subsequence, which in turn comprises multiple pyrolysis subsequences;

Fig. 4     shows a variant of the method of Fig. 1, comprising multiple transformation subsequences, which in turn comprise only one pyrolysis subsequence each;

Fig. 5     shows a variant of the method of Fig. 1, comprising multiple transformation subsequences, which in turn comprise multiple pyrolysis subsequences each;

Fig. 6     shows in schematic cross-sections different substrate configurations for a bridge tape element, for the invention;

Fig. 7     shows a schematic diagram of the progress of a part of the inventive method according to an example based on the variant of Fig. 3;

Fig. 8     illustrates in a schematic diagram different options for the transformation step in a method for producing a bridge tape element, in accordance with a part of the invention;

Fig. 9a    illustrates schematically a method not according to the invention for producing a superconducting joint of REBCO tapes with a starting situation;

Fig. 9b    illustrates the variant of Fig. 9a, with a step a) of preparation;

Fig. 9c    illustrates the variant of Fig. 9a, with a step b) of arrangement;

Fig. 9d    illustrates the variant of Fig. 9a, with a step c) of bonding;

Fig. 9e    illustrates the variant of Fig. 9a, with a step d) of annealing/reoxygenation;

Fig. 10    illustrates schematically in cross-sections different options for the bonding step in a part of an inventive method for producing a superconducting joint of REBCO tapes in accordance with the invention;

Fig. 11    illustrates in a schematic diagram the deposition of auxiliary REBCO layers in the end regions of the first and second REBCO base tapes, in a variant of the inventive method for producing a superconducting joint.

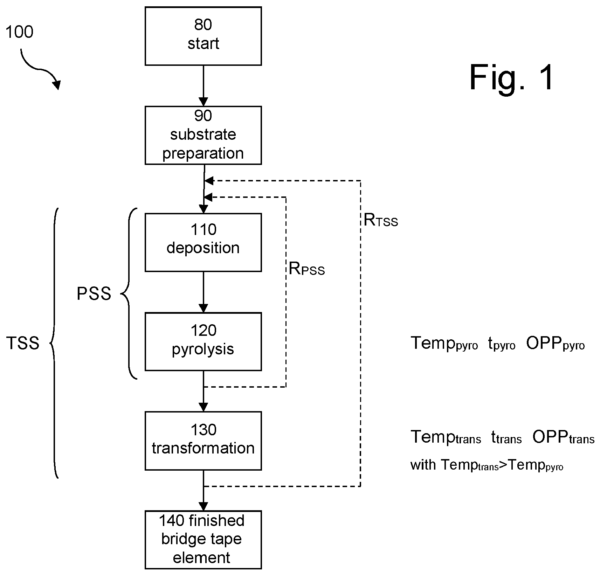

**Fig.** 1 shows in a schematic flow diagram the course of the method 100 for producing a bridge tape element, in accordance with a part of the invention, in an illustrative example.

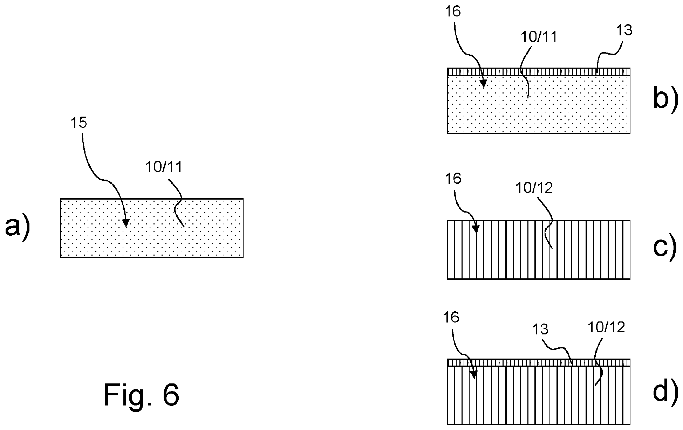

When the method has started 80, first a substrate is prepared 90. The substrate is chosen as a silver substrate, which may be made of textured or non-textured silver material, and which may be equipped with one or more buffer layers (see also Fig. 6).

Next, in a deposition step 110, a REBCO precursor solution is deposited on the substrate, for example by spin coating or ink jet printing. The REBCO precursor solution contains a solvent, for example alcohol, and dissolved REBCO precursor salts, for example acetates. The salts contain elements that later become REBCO. The REBCO precursor solution generally contains some organic content.

In particular, the REBCO precursor solution can be chosen as a pure TFA (trifluoroacetate) precursor solution, or a low fluorine precursor solution, both are suitable for basically all CSD process variants. Further, a fluorine free precursor solution can be chosen, in particular when only one transformation subsequence comprising only few pyrolysis subsequences (such as two or three) are chosen; fluorine free precursor solutions are preferred for industrial scale production, since they are environmentally friendly.

After deposition 110, a wet gel-like REBCO precursor layer is obtained, which contains an amorphous mixture of REBCO components including organic content.

Next, a pyrolysis step 120 is performed. The pyrolysis step includes a first stage heat treatment, for example at a temperature $Temp_{pyro}$ from 300°C to 550°C, with a dwelling time $t_{pyro}$ of for example between 10 minutes and 60 minutes. Ramp rates are typically on the order of 1-20°C/min, or even lower for thick layers. Typically, pure oxygen is chosen as atmosphere, with an oxygen partial pressure $OPP_{pyro}$ of 1 bar. During pyrolysis, the gel-like REBCO precursor layer changes into an amorphous REBCO component layer. The organic content is burnt out during pyrolysis 120, so the amorphous REBCO component layer is (basically) free from organic content.

The entirety of a deposition step 110 and a pyrolysis step 120 is also called a pyrolysis subsequence PSS here. If desired, after a first pyrolysis subsequence PSS, one or more further pyrolysis subsequences PSS may follow immediately, i.e. the pyrolysis subsequence PSS is repeated. The number of repetitions (following the first pyrolysis subsequence) are called $R_{PSS}$ here. By using further pyrolysis subsequences, a thicker amorphous REBCO component layer can be built up.

Then a transformation step 130 follows. During the transformation step 130, the REBCO component layer built up by one or more previous pyrolysis subsequences PSS is changed into a REBCO material layer containing polycrystalline or textured REBCO, typically in 123 phase. The transformation step 130 involves a second stage heat treatment, for example at a temperature $Temp_{trans}$ of between 750°C and 850°C and a dwelling time (also called crystallization time) $t_{trans}$ of between 5 minutes and 180 minutes. Ramp rates are typically on the order of 10-100°C/min, or even lower for thick layers. In case a textured REBCO material layer is to be generated, atmosphere is typically chosen with an oxygen partial pressure $OPP_{trans}$ with a corresponding oxygen concentration of 10-1000 ppm. In case a polycrystalline REBCO material layer is to be generated, atmosphere is typically chosen as pure oxygen, with an oxygen partial pressure $OPP_{trans}$ of 1 bar. In general, $Temp_{trans} > Temp_{pyro}$, and often further $t_{trans} \geq t_{pyro}$.

The entirety of one or more pyrolysis subsequences PSS followed by a transformation step 130 is also called a transformation subsequence TSS. If desired, after a first transformation subsequence TSS, one or more further transformation subsequences TSS may follow immediately, i.e. the transformation subsequence is repeated. The number of repetitions (following the first transformation subsequence) are called $R_{TSS}$ here. By using further transformation subsequences TSS, multiple REBCO material layers can be piled up to obtain a thicker final REBCO layer.

After the last transformation subsequence TSS, or its last transformation step 130, respectively, the bridge tape element is finished 140.

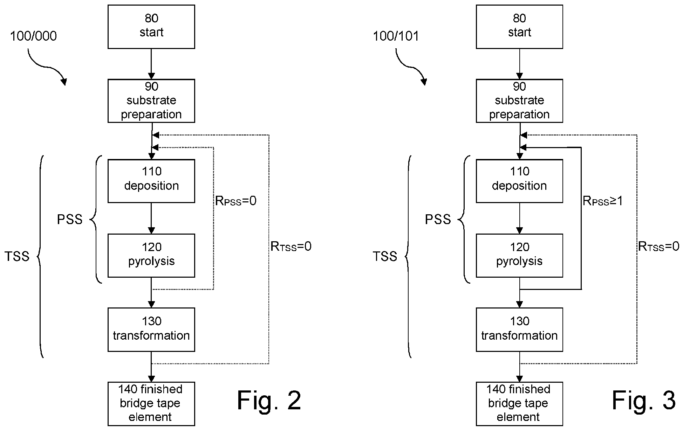

In Figures 2 through 5, some preferred variants of the method 100 of Fig. 1 are illustrated in more detail.

In the variant 000 of **Fig. 2,** the method 100 includes only one pyrolysis subsequence PSS (i.e. only one deposition step 110 and one pyrolysis step 120, i.e. $R_{PSS}=0$), followed by a single transformation step 130. Accordingly, there is also only one transformation subsequence TSS altogether ($R_{TSS}=0$). This variant is particularly simple and quick, and can be used to prepare comparably thin REBCO layers, with a thickness of up to about 500 nm.

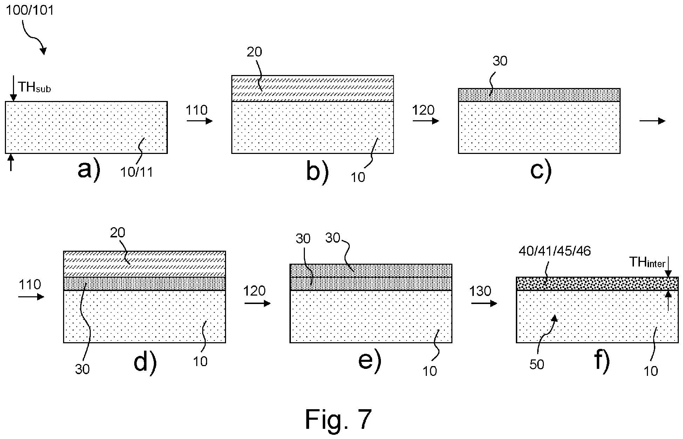

In the variant 101 of **Fig. 3,** the method 100 includes multiple pyrolysis subsequences PSS performed in sequence, i.e. $R_{PSS} \geq 1$. For example $R_{PSS}$ can be chosen as 1, so all in all 2 pyrolysis subsequences PSS are performed (see Fig. 7 for this example). Then follows a single (or common) transformation step 130. Accordingly, there is only one transformation subsequence TSS altogether ($R_{TSS}=0$). This variant is industrially friendly, since it requires only one expensive transformation step 130 at higher temperature, while a higher thickness of the REBCO layer of the bridge tape element can be achieved, in particular between 500 nm and 1 μm. Since only one transformation step is performed, the REBCO material layer obtained is very homogeneous, showing no interlayer boundaries (that may occur in case of multiple transformation subsequences, at the borders of individual REBCO material layers obtained in an individual transformation step each).

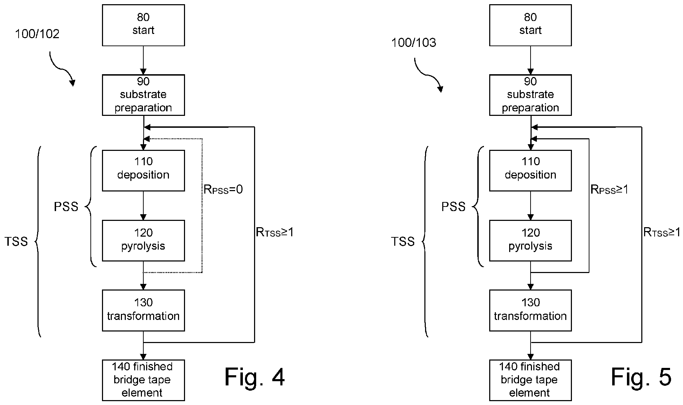

**Fig. 4** illustrates a variant 102 of the method 100, wherein multiple transformation subsequences TSS are performed (i.e. $R_{TSS} \geq 1$), and wherein each transformation subsequence TSS includes only one pyrolysis subsequence PSS (i.e. $R_{PSS}=0$). By choosing this variant, thicker REBCO layers may be achieved by piling up multiple REBCO material layers obtained after each transformation step 130, for example for a REBCO layer thickness of 1 $\mu$m-5$\mu$m. This variant 102 is preferred in case that (due to process parameters) the thickness limit of an individual pyrolysis step PSS is about the same as the thickness limit of an individual transformation step 130.

**Fig. 5** illustrates a variant 103 of the method 100 wherein multiple transformation subsequences TSS are performed (i.e. $R_{TSS}\geq1$), and wherein each transformation subsequence TSS includes multiple pyrolysis subsequences PSS (i.e. $R_{PSS}\geq1$). By choosing this variant, again thicker REBCO layers may be achieved by piling up multiple REBCO material layers obtained after each transformation step 130, for example for a REBCO layer thickness of 1 $\mu$m-5$\mu$m. This variant may achieve particularly thick REBCO layers with a lower number of high temperature transformation steps, what can save costs.

Note that further variants are possible, for example by choosing a different number of pyrolysis subsequences in different transformation subsequences.

**Fig. 6** illustrates different substrate configurations that may be used in a part of the inventive method for producing a bridge tape element. Note that in all configurations, the substrate is a silver substrate 10, with an Ag content of 75 weight% or more.

In the most simple case, shown in part a), the silver substrate 10 is chosen as a non-textured silver substrate 11, i.e. it is made of a non-textured silver material, without any buffer layers (functionally "non-textured substrate" 15). This is particularly inexpensive, and can be used when a polycrystalline REBCO material layer is to be generated in the transformation step (or steps).

As shown in part b), on a non-textured silver substrate 11, a buffer layer 13 (or multiple buffer layers 13) can be deposited.

As shown in part c), a textured silver substrate 12 can be chosen as the silver substrate 10, made of textured silver material.

As shown in part d), a textured silver substrate 12 with a buffer layer 13 (or multiple buffer layers 13) may be chosen may be chosen.

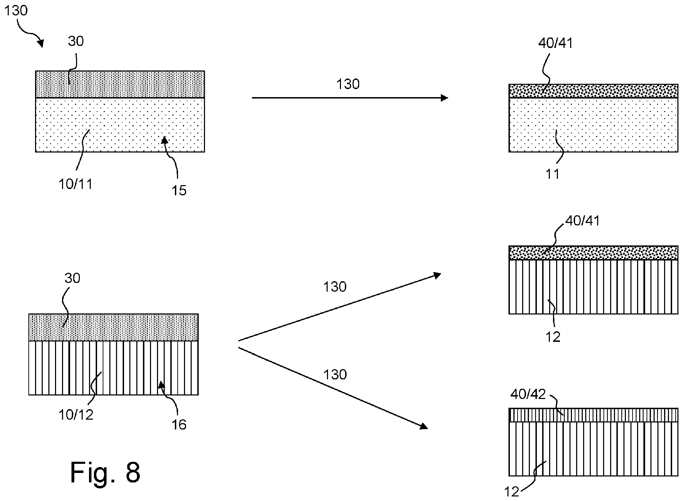

The substrate configurations of parts b), c) and d) of Fig. 6 are considered as functionally "textured substrates" 16, which allow generation of textured REBCO material layers in the transformation step (or steps). However note that the functionally "textured substrates" 16 may also be used if polycrystalline REBCO material layers are to be generated in the transformation step (or steps), see Fig. 8 below.

By way of example, **Fig. 7** illustrates the course of a part of the inventive method 100 according to the variant 101 of Fig. 3 above.

In the illustrated example, a non-textured silver substrate 11 without buffer layers has been chosen as the silver substrate 10, see part a). Note that a typical thickness $TH_{sub}$ of the silver substrate 10 is between 25 $\mu$m and 2.5 mm.

In a first deposition step 110, a first gel-like REBCO precursor layer 20 is deposited on the silver substrate 10, see part b).

Then a first pyrolysis step 120 is done, which changes the first gel-like precursor layer 20 into a first amorphous REBCO component layer 30, see part c). Note that the pyrolysis reduces the layer thickness about a factor of 2.

Then a second deposition step 110 is done, such that a second gel-like REBCO precursor layer 20 is deposited on the silver substrate 10, namely on top of the first amorphous REBCO component layer 30, see part d).

In a second pyrolysis step 120, said second gel-like REBCO precursor layer 20 changes into a second amorphous REBCO component layer 30 on top of the previous amorphous REBCO precursor layer 30, see part e). Up to now, two pyrolysis subsequences have been accomplished, and two amorphous REBCO component layers have been piled up on the silver substrate 10.

In the example shown here, then a transformation step 130 follows, which changes the amorphous REBCO component layers 30 piled up before into a REBCO material layer 40, which is here a polycrystalline REBCO material layer 41, see part f). Note that the transformation step reduces the layer thickness again about a factor of 2.

Only one transformation step is provided here ("common" transformation step for all amorphous REBCO components generated in the CSD process), so the bridge tape element 50 is finished then. The REBCO material layer 40 obtained after the (only) transformation step 130 is here also the final REBCO layer 45 of the bridge tape element 50, which is here a polycrystalline REBCO layer 46. Note that a typical final thickness $TH_{inter}$ of the REBCO layer 45 after the transformation step is from 400 nm to 6 $\mu$m, and often from 500 nm to 5 $\mu$m.

**Fig. 8** illustrates different options for the transformation step 130, in accordance with a part of the invention. Depending on the silver substrate 10 (functionally "textured substrate" or functionally "non-textured substrate", see Fig. 6) and on the parameters of the transformation step 130, in particular the atmosphere chosen, the generated REBCO material layer 40 may be polycrystalline or textured.

In part a) of Fig. 8, when the substrate 10 is a non-textured silver substrate 11 without a buffer layer (functionally "non-textured substrate" 15), then only a polycrystalline REBCO material layer 41 can be obtained after the transformation step 130. The transformation step 130 is typically done under pure oxygen content atmosphere, with an oxygen partial pressure of 1 bar then.

In part b) of Fig. 8, when the substrate 10 is a functionally "textured substrate" 16, here with a textured silver substrate 12 without buffer layers, then either a polycrystalline REBCO material layer 41, upper branch, or alternatively a textured REBCO material layer 42, lower branch, can be obtained, depending on the transformation parameters. In order to obtain a polycrystalline REBCO material layer 42, transformation step 130 is typically done under pure oxygen atmosphere. In order to obtain a textured REBCO material layer 41, transformation step 130 is typically done under low oxygen content atmosphere, such as at 10-1000 ppm oxygen concentration. It should be noted that when textured REBCO is obtained on a silver substrate that is functionally textured, epitaxial growth is not 100%, as the cell parameters do not perfectly match. Note that further parameters, such as the transformation temperature $Temp_{trans}$ or the dwelling time $t_{trans}$ may be adapted to optimize the quality of the respective desired REBCO material layer 40 (or the final REBCO layer, respectively).

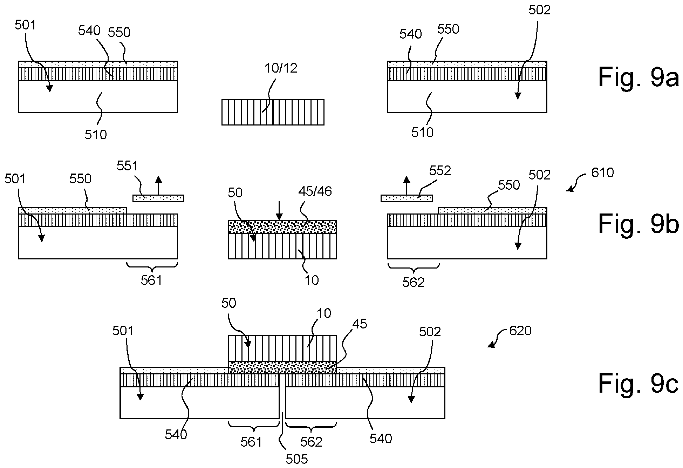

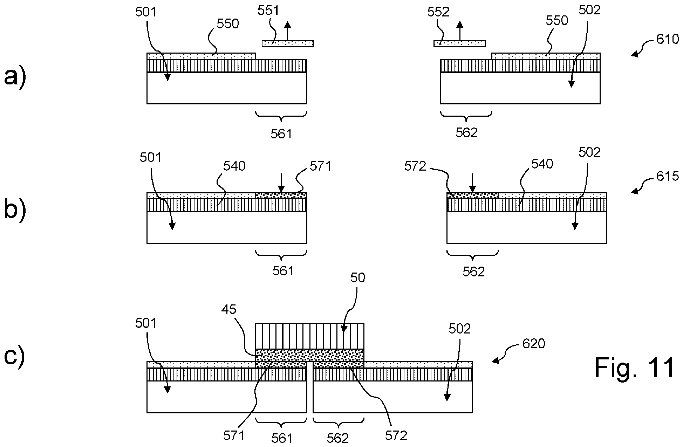

Figures 9a-9e illustrate a method for producing a superconducting joint of REBCO tapes. Figures 9a-9e serve the purpose of general illustration. Auxiliary REBCO layers 571, 572, as provided in step a') of the inventive method, are not displayed here (but see Fig.11).

At the start of the procedure, two REBCO base tapes are provided, called first REBCO base tape 501 and second REBCO base tape 502, as well as a silver substrate 10 for a bridge tape element, compare **Fig. 9a.** The two REBCO base tapes 501, 502 are intended to be connected in a superconducting manner by the bridge tape element.

The first REBCO base tape 501 comprises a base metal substrate 510, typically made of stainless steel or a Ni-based alloy, such as Hastelloy. Note that the base metal substrate 510 allows only a very slow oxygen diffusion through it. On the base metal substrate 510 is located a base REBCO layer 540 and a stabilizing layer 550, for example made of silver, which covers the base REBCO layer 540 on its top. The second REBCO base tape 502 is built analogously. The silver substrate 10 is here a textured silver substrate 12.

In a step a) 610, also referred to as preparation step, see **Fig. 9b,** in a first end region 561 of the first REBCO base tape 501, the stabilizing layer 550 is being removed. In other words, a part 551 of the stabilizing layer 550 is removed. Typically, removal is done by an etching process (e.g. wet etching). Analogously, in a second end region 562 of the second REBCO base tape 502, the stabilizing layer 550 is removed, i.e. part 552 of the stabilizing layer 550 is removed. Further, a REBCO layer 45, which is here formed as a polycrystalline REBCO layer 46, is deposited in the silver substrate 10 by a CSD process, as described in particular in Fig. 1 above, resulting in a bridge tape element 50.

In a step b) 620, also referred to as arrangement step, see **Fig. 9c,** the first REBCO base tape 501 and the second REBCO base tape 502 are arranged next to each other, with their REBCO films arranged on the same side (here towards the top), and their end regions 561, 562 neighboring each other. Note that the first and second REBCO base tapes 501, 502 may be touching each other (not shown) or may be arranged with a small gap 505, as shown here. If desired, the first and second REBCO base tapes 501, 502 may be fixed to a common basis in this situation, for example with clamps (not shown). Further, the bridge tape element 50 is arranged on top of the first and second REBCO base tapes 501, 502. In the first end region 561, the first REBCO base tape 501 overlaps with the left side part of the bridge tape element 50, and the REBCO base layer 540 touches the REBCO layer 45 of the bridge tape element 50. Further, in the second end region 562, the second REBCO base tape 502 overlaps with the right side part of the bridge tape element 50, and the REBCO base layer 540 touches the REBCO layer 45 of the bridge tape element 50.

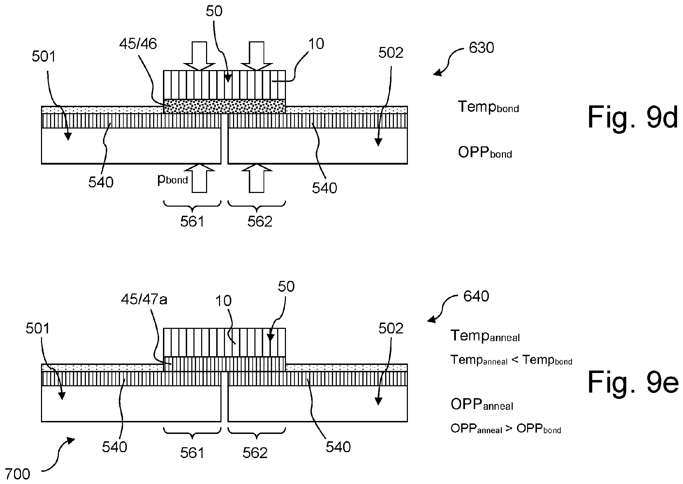

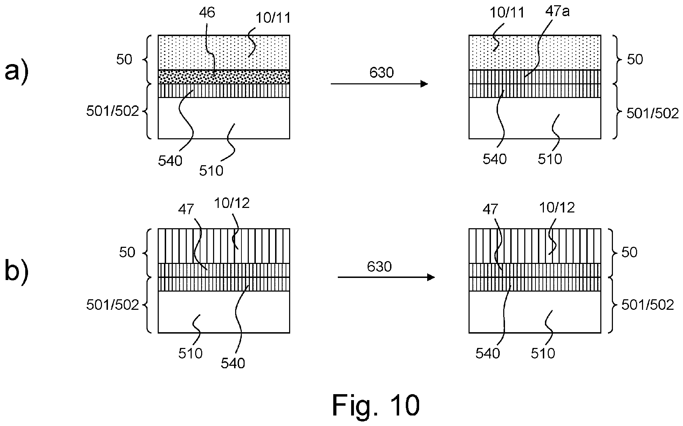

Then a step c) 630, also called bonding step, follows, see **Fig. 9d.** In the bonding step 630, the first and second REBCO base tapes 501, 502 on the one hand, and the bridge tape element 50 on the other hand, are pressed together at least in the two end regions 561, 562. A mechanical pressure $p_{bond}$ is applied, typically between 5 MPa and 50 MPa. Further, a (bonding) heat treatment is applied with a temperature $Temp_{bond}$, chosen for example between 750°C and 900°C, at least in the end regions 561, 562. Note that $Temp_{bond}$ is chosen such that it is below the melting point of the silver substrate 10 of the bridge tape element 50. Further, a low partial pressure of oxygen $OPP_{bond}$ is applied, that corresponds to an oxygen concentration of 10-1000 ppm, what helps to improve the bonding between the REBCO base layers 540 of the first and second REBCO base tapes 501, 502 on the one hand, and the REBCO layer 45 of the bridge tape element 50 on the other hand. The heat treatment applies a bonding time (or dwelling time) $t_{bond}$ of for example between 1 minute and 60 minutes. In the example shown, the polycrystalline REBCO layer 46 of the bridge tape element 50 undergoes a re-texturing during the bonding step 630, so the REBCO layer 45 of the bridge tape element 50 becomes textured then (see textured REBCO layer 47a in Fig. 9e). In case of a textured REBCO layer of the bridge tape element 50 before bonding, then during the bonding step 630, a bonding without re-texturing of the REBCO material layer occurs (not shown in Fig. 9d, but compare Fig. 10).

Then a step d) 640 follows, also referred to as annealing step or reoxygenation step, see **Fig. 9e.** The annealing step 640 involves a heat treatment at a temperature $Temp_{anneal}$, for example chosen between 300°C and 600°C, for an annealing time (or dwelling time) $Temp_{anneal}$, for example of up to 10 hours, at least in the end regions 561, 562. Here, the oxygen partial pressure $OPP_{anneal}$ is chosen high, in general at least with 0.5 bar, for example by using a pure oxygen atmosphere (1 bar oxygen partial pressure). Further the following applies: $Temp_{bond} > Temp_{anneal}$, further $t_{anneal} \geq t_{bond}$, and further $OPP_{anneal} > OPP_{bond}$. Note that in step d) 640, no more mechanical pressure is applied any more here. By the annealing step 640, oxygen is replenished in the base REBCO layers 540 and the REBCO layer 45, and good superconducting current carrying capacity is achieved through them. Since the bridge tape element 50 is formed with a silver substrate 10, oxygen diffusion is fast from the back (in Fig. 9d from top side) of the silver substrate 10 through the silver substrate 10 and into the REBCO layer 45 and into the base REBCO layers 540 in the end regions 561, 562.

After the annealing step 640, the superconducting joint 700 of REBCO tapes, i.e. of the first and second REBCO base tapes 501, 502, by means of the bridge tape element 50 is complete.

**Fig. 10** illustrates in cross-sections different options for the bonding step 630 for a part of the inventive method for producing a superconducting joint (compare Fig. 9a-9e above).

In case that the bridge tape element 50 comprises (after its production) a polycrystalline REBCO layer 46, see part a), then during the bonding step 630, the polycrystalline REBCO layer 46 transforms into a textured REBCO layer 47a by re-crystallization. In the case shown here in part a), the silver substrate 10 is a functionally "non-textured substrate" 15, and the textured REBCO layer 47a bases its texture on the texture from the base REBCO tapes 501, 502 or their textured base REBCO layers 540, respectively. Then the textured REBCO layer 47a can experience some gradient in its texture along its thickness.

In case the bridge tape element 50 comprises (after its production) already a textured REBCO layer 47, see part b), then during the bonding step 630 only bonding without re-texturing occurs. The textured REBCO layer 47 basically keeps its previous texture, and so do the textured base REBCO tapes 540.

**Fig. 11** illustrates in a schematic drawing the deposition of the auxiliary REBCO layers 571, 572 in the course of the inventive method for producing a superconducting joint 700 in a variant, similar to the method variant illustrated in Figs. 9a-9e above. Only the major differences are explained in more detail here.

After the parts 551, 552 of the stabilizing layers 550 have been removed from the first and second REBCO base tapes 501, 502 in the first and second end regions 561, 562 during preparation step 610, see part a) of Fig. 11, then auxiliary REBCO layers 571, 572 are deposited in a CSD process on the exposed base REBCO layers 540 of the first and second REBCO base tape 501, 502 in the end regions 561, 562 during a step a') 615, also called auxiliary REBCO layer deposition step, see part b) of Fig. 11.

Note that this CSD process may be performed analogously to the CSD process used to deposit the REBCO layer on the silver substrate of the bridge tape element (see above, e.g. in Fig. 7). In the example shown in Fig. 11, the auxiliary REBCO layers 571, 572 contain polycrystalline REBCO material, but it is also possible to obtain textured REBCO material if desired (depending on the parameters of the transformation step or steps of the CSD process for preparing the auxiliary REBCO layers 571, 572).

In the subsequent arrangement step 620, see part c) of Fig. 11, the bridge tape element 50 is placed onto the first and second REBCO base tapes 501, 502, with the bridge tape element 50 overlapping in the end regions 561, 562 with the first and second REBCO base tapes 501, 502. The auxiliary REBCO layers 571, 572 on the one hand, and the REBCO layer 45 of the bridge tape element 50 on the other hand, are facing each other and contacting each other.

In the following bonding step and annealing step (compare Fig. 9d, 9e), superconducting connecting will be established through the auxiliary REBCO layers 571, 572.

<u>List of reference signs</u>

| 000 | method variant (having only one transformation subsequence, which has only one pyrolysis subsequence) |
|---|---|
| 10 | silver substrate |
| 11 | non-textured silver substrate |
| 12 | textured silver substrate |
| 13 | buffer layer |
| 15 | functionally non-textured substrate |
| 16 | functionally textured substrate |
| 20 | gel-like REBCO precursor layer |
| 30 | amorphous REBCO component layer |
| 40 | REBCO material layer |
| 41 | polycrystalline REBCO material layer |
| 42 | textured REBCO material layer |
| 45 | REBCO layer |
| 46 | polycrystalline REBCO layer |
| 47 | textured REBCO layer (obtained after bridge tape production) |
| 47a | textured REBCO layer (obtained after bonding) |
| 50 | bridge tape element |
| 80 | start (of bridge tape element production) |
| 90 | substrate preparation |
| 100 | method for producing a bridge tape element |
| 101 | method variant (with multiple pyrolysis subsequences) |
| 102 | method variant (with multiple transformation subsequences) |
| 103 | method variant (with multiple transformation subsequences each having multiple preparation subsequences) |
| 110 | deposition step |
| 120 | pyrolysis step |
| 130 | transformation step |
| 140 | finished bridge tape element obtained |

| 501 | first REBCO base tape (REBCO tape to be connected in joint) |
| 502 | second REBCO base tape (REBCO tape to be connected in joint) |
| 505 | gap |
| 510 | base metal substrate |
| 540 | base REBCO layer |
| 550 | stabilizing layer |
| 551, 552 | part of stabilizing layer |
| 561 | first end region |
| 562 | second end region |
| 571, 572 | auxiliary REBCO layer |
| 610 | step a) / preparation step |
| 615 | step a') / auxiliary REBCO layer deposition step |
| 620 | step b) / arrangement step |
| 630 | step c) / bonding step |
| 640 | step d) / annealing step / reoxygenation step |
| 700 | superconducting joint |
| $OPP_{anneal}$ | oxygen partial pressure during annealing |
| $OPP_{bond}$ | oxygen partial pressure during bonding |
| $OPP_{pyro}$ | oxygen partial pressure during pyrolysis |
| $OPP_{trans}$ | oxygen partial pressure during transformation |
| PSS | pyrolysis subsequence |
| $Temp_{anneal}$ | temperature of heat treatment in annealing step |
| $Temp_{bond}$ | temperature of heat treatment in bonding step |
| $Temp_{pyro}$ | temperature of first stage heat treatment (pyrolysis) |
| $Temp_{trans}$ | temperature of second stage heat treatment (transformation) |
| $TH_{inter}$ | thickness of (final) REBCO layer |
| $TH_{sub}$ | thickness of silver substrate |
| $t_{anneal}$ | dwelling time of annealing step |
| $t_{bond}$ | dwelling time of bonding step |
| $t_{pyro}$ | dwelling time of first stage heat treatment (pyrolysis) |
| $t_{trans}$ | dwelling time of second stage heat treatment (transformation) |
| TSS | transformation subsequence |
| $R_{PSS}$ | number of repetitions of pyrolysis subsequences (after the first one) |
| $R_{TSS}$ | number of repetitions of pyrolysis subsequences (after the first one) |

**Claims**

1. A method for producing a superconducting joint (700) of rare earth barium copper oxide, REBCO, tapes (501, 502), with the following steps:

Step a) (610) at a first REBCO base tape (501), comprising at least a base metal substrate (510), a base REBCO layer (540) located on the base metal substrate (510), and a stabilizing layer (550) located on the base REBCO layer (540), the stabilizing layer (550) is removed in a first end region (561);

and at a second REBCO base tape (502), comprising at least a base metal substrate (510), a base REBCO layer (540) located on the base metal substrate (510), and a stabilizing layer (550) located on the base REBCO layer (540), the stabilizing layer (550) is removed in a second end region (562);

and a bridge tape element (50) is produced by deposition of a REBCO layer (45) by a chemical solution deposition, CSD, process on a substrate being a silver substrate (10), wherein the silver substrate (10) is made of silver or a silver alloy containing at least 75 weight% of silver, wherein the CSD process includes

- at least one deposition step (110), wherein a REBCO precursor solution is deposited on the silver substrate (10), resulting in a gel-like REBCO precursor layer (20),

with the REBCO precursor solution comprising a solvent and dissolved REBCO precursor salts including organic content,
and with the gel-like REBCO precursor layer (20) containing an amorphous mixture of REBCO components including organic content,

- at least one pyrolysis step (120), wherein a gel-like REBCO precursor layer (20) is pyrolysed in a first stage heat treatment, resulting in an amorphous REBCO component layer (30),
with the amorphous REBCO component layer (30) containing an amorphous mixture of REBCO components and being devoid of organic content;
- at least one transformation step (130), wherein at least one amorphous REBCO component layer (30) is transformed in a second stage heat treatment, resulting in a REBCO material layer (40),
with the REBCO material layer (40) containing polycrystalline or textured REBCO;

step a') (615) respective auxiliary REBCO layers (571, 572) are deposited by a further CSD process on the base REBCO layers (540) of the first REBCO base tape (501) in the first end region (561) and of the second REBCO base tape (502) in the second end region (562);

Step b) (620) the first REBCO base tape (501), the second REBCO base tape (502) and the bridge tape element (50) are arranged such that in the first end region (561), the bridge tape element (50) overlaps with and contacts the first REBCO base tape (501), and in the second end region (562), the bridge tape element (50) overlaps with and contacts the second REBCO base tape (502), with the REBCO layer (45) of the bridge tape element (50) and the base REBCO layers (540) of the first REBCO base tape (501) and the second REBCO base tape (502) facing each other;

Step c) (630) in the first end region (561) and in the second end region (562), the first REBCO base tape (501), the second REBCO base tape (502) and the bridge tape element (50) are pressed together with a mechanical pressure $p_{bond}$ during a heat treatment at a temperature $Temp_{bond}$ below the melting temperature of the silver substrate (10) in a low oxygen atmosphere with an oxygen partial pressure $OPP_{bond}$ during a bonding time $t_{bond}$;

Step d) (640) in the first end region (561) and in the second end region, (562) the first REBCO base tape (501), the second REBCO base tape (502) and the bridge tape element (50) undergo a heat treatment at a temperature $Temp_{anneal}$, with $Temp_{anneal} < Temp_{bond}$, in a high oxygen atmosphere with an oxygen partial pressure $OPP_{anneal}$, with $OPP_{anneal} > OPP_{bond}$, during an annealing time $t_{anneal}$, with $t_{anneal} \geq t_{bond}$, in particular wherein in step d) no mechanical pressure is applied any more.

2. A method (100) according to claim 1, **characterized in that** the CSD process of step a) and/or the further CSD process of step a') include(s) a plurality of pyrolysis subsequences (PSS), wherein each pyrolysis subsequence (PSS) includes a deposition step (110) followed by a pyrolysis step (120).

3. A method (100) according to claim 2, **characterized in that** the CSD process of step a) and/or the further CSD process of step a') include(s) performing a plurality of subsequent pyrolysis subsequences (PSS) before performing a next transformation step (130).

4. A method (100) according to claim 3, **characterized in that** the CSD process of step a) and/or the further CSD process of step a') include(s) performing a common transformation step (130), wherein all amorphous REBCO component layers (30) obtained in all pyrolysis steps (120) are transformed in common.

5. A method (100) according to claim 2, **characterized in that** the CSD process of step a) and/or the further CSD process of step a') include(s) a plurality of subsequent transformation subsequences (TSS), wherein each transformation subsequence (TSS) includes at least one pyrolysis subsequence (PSS) followed by a transformation step (130).

6. A method (100) according to claim 5, **characterized in that** at least one transformation subsequence (TSS), preferably each transformation subsequence (TSS), comprises only one pyrolysis subsequence (PSS).

7. A method (100) according to claim 5 or 6, **characterized in that** at least one transformation subsequence (TSS), preferably each transformation subsequence (TSS), comprises a plurality of subsequent pyrolysis subsequences (PSS).

8. A method (100) according to one of the previous claims, **characterized in that** at least one first stage heat treatment, in particular each first stage heat treatment, includes a dwell at a temperature $Temp_{pyro}$, with $300°C \leq Temp_{pyro} \leq 550 °C$ for a pyrolysis time $t_{pyro}$, with $10 \min \leq t_{pyro} \leq 60 \min$.

9. A method (100) according to one of the preceding claims, **characterized in that** at least one second stage heat treatment, in particular each second stage heat treatment, includes a dwell at a temperature $Temp_{trans}$, with between $750°C \leq Temp_{trans} \leq 850 °C$ for a crystallization time $t_{trans}$, with $5 \min \leq t_{trans} \leq 180 \min$.

10. A method (100) according to one of the preceding claims, **characterized in that** at least one first stage heat treatment, in particular each first stage heat treatment, is done in pure oxygen atmosphere.

11. A method (100) according to one of the claims 1 through 10, **characterized in that** at least one second stage heat treatment, in particular each second stage heat treatment, is done in an atmosphere with an oxygen partial pressure with a corresponding oxygen concentration of 10-1000 ppm.

12. A method (100) according to one of the claims 1 through 10, **characterized in that** at least one second stage heat treatment, in particular each second stage heat treatment, is done in pure oxygen atmosphere.

13. A method (100) according to one of the claims 1 through 12, **characterized in that** the REBCO layer (45) is deposited directly on the silver substrate (10).

**14.** A method (100) according to one of the claims 1 through 12, **characterized in that** the silver substrate (10) is provided with one or more buffer layers (13), and the REBCO layer (45) is deposited on top of the one or more buffer layers (13) of the silver substrate (10).

**15.** A method (100) according to one of the claims 1 through 14, **characterized in that** the silver substrate (10) is chosen as a textured silver substrate (12),

in particular with the silver substrate (10) exposing a surface in a 001 or 110 orientation to the REBCO layer (45).

**16.** A method (100) according to one of the claims 1 through 14, **characterized in that** the silver substrate (10) is chosen as a non-textured polycrystalline silver substrate (11).

**17.** A method (100) according to one of the preceding claims, **characterized in that** the silver substrate (10) is chosen with a thickness $TH_{sub}$, with $25\mu m \leq TH_{sub} \leq 2.5mm$.

**18.** A method (100) according to one of the preceding claims, **characterized in that** the REBCO layer (45) is deposited on the silver substrate (10) with a thickness $TH_{inter}$, with $500nm \leq TH_{inter}$, in particular with $1\mu m \leq TH_{inter} \leq 5\mu m$.

**19.** A method according to one of the preceding claims, **characterized in that** during step c),

$$5 \text{ MPa} \leq p_{bond} \leq 50 \text{ MPa},$$

and/or $750°C \leq Temp_{bond} \leq 900°C$, and/or the oxygen partial pressure $OPP_{bond}$ has a corresponding oxygen concentration of 10-1000 ppm, and/or $1 \text{ min} \leq t_{bond} \leq 60 \text{ min}$, and/or that during step d),

$$300°C \leq Temp_{anneal} \leq 600°C,$$

and/or $0.5 \text{ bar} \leq OPP_{anneal}$, in particular wherein a pure oxygen atmosphere is applied, and/or $0h \leq t_{anneal} \leq 10h$.

**20.** A superconducting joint (700) of rare earth barium copper oxide, REBCO, tapes (501, 502), with the superconducting joint (700) comprising a first REBCO base tape (501) having a first end region (561), a second REBCO base tape (502) having a second end region (562), and a bridge tape element (50), with the bridge tape element (50) comprising a substrate and a REBCO layer (45) located on the substrate, wherein the REBCO layer (45) is a REBCO layer (45) deposited by a chemical solution deposition, CSD, process on the substrate being a silver substrate (10), wherein the silver substrate (10) is made of silver or a silver alloy containing at least 75 weight% of silver, with the first REBCO base tape (501) and the second REBCO base tape (502) each comprising at least a base metal substrate (510), a base REBCO layer (540) located on the base metal substrate (510), and a stabilizing layer (550) located on the base REBCO layer (540),

wherein in the first end region (561) and the second end region (562), the first REBCO tape (501) and the second REBCO tape (502) are devoid of the stabilizing layer (550), and wherein auxiliary REBCO layers (571, 572) are deposited by a further CSD process on the base REBCO layer (540) in the first end region (561) and the second end region (562), and wherein in the first end region (561) the bridge tape element (50) overlaps with the first REBCO base tape (501), and in the second end region (562) the bridge tape element (50) overlaps with the second REBCO base tape (502), with the REBCO layer (45) of the bridge tape element (50) and the base REBCO layers (540) of the first REBCO base tape (501) and the second REBCO base tape (502) facing each other and being connected to each other, where the auxiliary REBCO layers (571, 572) on the one hand, and the REBCO layer (45) of the bridge tape element (50) on the other hand, are facing each other and contacting each other, in particular wherein the superconducting joint (700) of REBCO tapes (501, 502) is produced by a method according to one of claims 1 through 19.

**21.** Use of a superconducting joint (700) of REBCO tapes (501, 502) according to claim 20 or produced according to one of claims 1 through 19, in a superconducting magnet of an NMR spectrometer or MRI tomograph, in particular wherein the superconducting magnet is operated in persistent mode.

**Patentansprüche**

**1.** Verfahren zum Herstellen einer supraleitenden Verbindungsstelle (700) aus Seltenerdbariumkupferoxidbändern, REBCO-Bändern (501, 502), mit den folgenden Schritten:

Schritt a) (610) an einem ersten REBCO-Basisband (501), umfassend mindestens ein Basismetallsubstrat (510), eine REBCO-Basisschicht (540), die sich auf dem Basismetallsubstrat (510) befindet, und eine Stabilisierungsschicht (550), die sich auf der REBCO-Basisschicht (540) befindet, wird die Stabilisierungsschicht (550) in einem ersten Endbereich (561) entfernt; an einem zweiten REBCO-Basisband (502), umfassend mindestens ein Basismetallsubstrat (510), eine REBCO-Basisschicht (540), die sich auf dem Basismetallsubstrat (510) befindet, und eine Stabilisierungsschicht (550), die sich auf der REBCO-Basisschicht (540) befindet, wird die Stabilisierungsschicht (550) in einem zweiten Endbereich (562) entfernt;

und ein Brückenbandelement (50) wird durch Abscheidung einer REBCO-Schicht (45) durch einen Prozess mit chemischer Lösungsabscheidung, CSD, auf einem Substrat, das ein Silbersubstrat (10), ist, hergestellt, wobei das Silbersubstrat (10) aus Silber oder einer Silberlegierung, die mindestens 75 Gewichts% Silber enthält, besteht, wobei der CSD-Prozess einschließt

- mindestens einen Abscheidungsschritt (110), wobei eine REBCO-Vorläuferlösung auf dem Silbersubstrat (10) abgeschieden wird, was in einer gelartigen REBCO-Vorläuferschicht (20) resultiert,

die REBCO-Vorläuferlösung umfassend ein Lösungsmittel und gelöste REBCO-Vorläufersalze einschließlich organischen Inhalts, und wobei die gelartige REBCO-Vorläuferschicht (20) eine amorphe Mischung aus REBCO-Komponenten einschließlich organischen Inhalts enthält,

- mindestens einen Pyrolyseschritt (120), wobei in einer Wärmebehandlung erster Stufe eine gelartige REBCO-Vorläuferschicht (20) pyrolysiert wird, was in einer amorphen REBCO-Komponentenschicht (30) resultiert,

wobei die amorphe REBCO-Komponentenschicht (30) eine amorphe Mischung aus REBCO-Komponenten enthält und frei von organischem Inhalt ist;

- mindestens einen Transformationsschritt (130), wobei mindestens eine amorphe REBCO-Komponentenschicht (30) in einer Wärmebehandlung zweiter Stufe transformiert wird, was in einer REBCO-Materialschicht (40) resultiert,

wobei die REBCO-Materialschicht (40) polykristallines oder texturiertes REBCO enthält;

Schritt a') (615) jeweilige zusätzliche REBCO-Schichten (571, 572) werden durch einen weiteren CSD-Prozess auf den REBCO-Basisschichten (540) des ersten REBCO-Basisbandes (501) in dem ersten Endbereich (561) und des zweiten REBCO-Basisbandes (502) in dem zweiten Endbereich (562) abgeschieden;

Schritt b) (620) das erste REBCO-Basisband (501), das zweite REBCO-Basisband (502) und das Brückenbandelement (50) sind derart angeordnet, dass in dem ersten Endbereich (561) das Brückenbandelement (50) das erste REBCO-Basisband (501) überlappt und berührt, und in dem zweiten Endbereich (562) das Brückenbandelement (50) das zweite REBCO-Basisband (502) überlappt und berührt, wobei die REBCO-Schicht (45) des Brückenbandelements (50) und die REBCO-Basisschichten (540) des ersten REBCO-Basisbandes (501) und des zweiten REBCO-Basisbandes (502) einander zugewandt sind;

Schritt c) (630) in dem ersten Endbereich (561) und in dem zweiten Endbereich (562) werden das erste REBCO-Basisband (501), das zweite REBCO-Basisband (502) und das Brückenbandelement (50) mit einem mechanischen Druck $p_{Bindung}$ während einer Wärmebehandlung bei einer Temperatur $Temp_{Bindung}$ unterhalb der Schmelztemperatur des Silbersubstrats (10) in einer sauerstoffarmen Atmosphäre mit einem Sauerstoffpartialdruck $OPP_{Bindung}$ während einer Bindungszeit $t_{Bindung}$ zusammengepresst;

Schritt d) (640) in dem ersten Endbereich (561) und in dem zweiten Endbereich (562) werden das erste REBCO-Basisband (501), das zweite REBCO-Basisband (502) und das Brückenbandelement (50) einer Wärmebehandlung bei einer Temperatur von $Temp_{glühen}$, mit $Temp_{glühen} < Temp_{Bindung}$, in einer sauerstofffreichen Atmosphäre mit einem Sauerstoffpartialdruck $OPP_{glühen}$, mit $OPP_{glühen} > OPP_{Bindung}$, während einer Glühzeit $t_{glühen}$, mit $t_{glühen} \geq t_{Bindung}$ unterzogen,

insbesondere wobei in Schritt d) kein mechanischer Druck mehr aufgebracht wird.

2. Verfahren (100) nach Anspruch 1, **dadurch gekennzeichnet,**

**dass** der CSD-Prozess von Schritt a) und/oder der weitere CSD-Prozess von Schritt a') eine Vielzahl von Pyrolysesubsequenzen (PSS) einschließt/einschließen, wobei jede Pyrolysesubsequenz (PSS) einen Abscheidungsschritt (110) gefolgt durch einen Pyrolyseschritt (120) einschließt.

**3.** Verfahren (100) nach Anspruch 2, **dadurch gekennzeichnet,**
dass der CSD-Prozess von Schritt a) und/oder der weitere CSD-Prozess von Schritt a') ein Durchführen einer Vielzahl von aufeinanderfolgenden Pyrolysesubsequenzen (PSS) einschließt/einschließen, bevor ein nächster Transformationsschritt (130) durchgeführt wird.

**4.** Verfahren (100) nach Anspruch 3, **dadurch gekennzeichnet,**
dass der CSD-Prozess von Schritt a) und/oder der weitere CSD-Prozess von Schritt a') das Durchführen eines gemeinsamen Transformationsschrittes (130) einschließt/einschließen, wobei alle amorphen REBCO-Komponentenschichten (30), die in allen Pyrolyseschritten (120) erhalten werden, gemeinsam transformiert werden.

**5.** Verfahren (100) nach Anspruch 2, **dadurch gekennzeichnet,**

**dass** der CSD-Prozess von Schritt a) und/oder der weitere CSD-Prozess von Schritt a') eine Vielzahl von aufeinanderfolgenden Transformationssubsequenzen (TSS) einschließt/einschließen,
wobei jede Transformationssubsequenz (TSS) mindestens eine Pyrolysesubsequenz (PSS) gefolgt durch einen Transformationsschritt (130) einschließt.

**6.** Verfahren (100) nach Anspruch 5, **dadurch gekennzeichnet, dass** mindestens eine Transformationssubsequenz (TSS), vorzugsweise jede Transformationssubsequenz (TSS), nur eine Pyrolysesubsequenz (PSS) umfasst.

**7.** Verfahren (100) nach Anspruch 5 oder 6, **dadurch gekennzeichnet, dass** mindestens eine Transformationssubsequenz (TSS), vorzugsweise jede Transformationssubsequenz (TSS), eine Vielzahl von aufeinanderfolgenden Pyrolysesubsequenzen (PSS) umfasst.

**8.** Verfahren (100) nach einem der vorhergehenden Ansprüche,
**dadurch gekennzeichnet, dass** mindestens eine Wärmebehandlung erster Stufe, insbesondere jede Wärmebehandlung erster Stufe, eine Verweilzeit bei einer Temperatur $Temp_{pyro}$, mit 300 °C$\leq Temp_{pyro}\leq$5550 °C für eine Pyrolysezeit $t_{pyro}$, mit 10 min$\leq t_{pyro}\leq$60 min einschließt.

**9.** Verfahren (100) nach einem der vorstehenden Ansprüche,
**dadurch gekennzeichnet, dass** mindestens eine Wärmebehandlung zweiter Stufe, insbesondere jede Wärmebehandlung zweiter Stufe, eine Verweilzeit bei einer Temperatur $Temp_{trans}$, mit zwischen 750 °C$\leq Temp_{trans}\leq$850 °C für eine Kristallisationszeit $t_{trans}$, mit 5 min$\leq t_{trans}\leq$180 min einschließt.

**10.** Verfahren (100) nach einem der vorstehenden Ansprüche,
**dadurch gekennzeichnet, dass** mindestens eine Wärmebehandlung erster Stufe, insbesondere jede Wärmebehandlung erster Stufe, in reiner Sauerstoffatmosphäre erfolgt.

**11.** Verfahren (100) nach einem der Ansprüche 1 bis 10, **dadurch gekennzeichnet, dass** mindestens eine Wärmebehandlung zweiter Stufe, insbesondere jede Wärmebehandlung zweiter Stufe, in einer Atmosphäre mit einem Sauerstoffpartialdruck mit einer entsprechenden Sauerstoffkonzentration von 10-1000 ppm erfolgt.

**12.** Verfahren (100) nach einem der Ansprüche 1 bis 10, **dadurch gekennzeichnet, dass** mindestens eine Wärmebehandlung zweiter Stufe, insbesondere jede Wärmebehandlung zweiter Stufe, in reiner Sauerstoffatmosphäre erfolgt.

**13.** Verfahren (100) nach einem der Ansprüche 1 bis 12, **dadurch gekennzeichnet, dass** die REBCO-Schicht (45) auf dem Silbersubstrat (10) direkt abgeschieden wird.

**14.** Verfahren (100) nach einem der Ansprüche 1 bis 12, **dadurch gekennzeichnet, dass** das Silbersubstrat (10) mit einer oder mehreren Pufferschichten (13) versehen ist, und die REBCO-Schicht (45) auf der einen oder den mehreren Pufferschichten (13) des Silbersubstrats (10) abgeschieden wird.

**15.** Verfahren (100) nach einem der Ansprüche 1 bis 14, **dadurch gekennzeichnet, dass** das Silbersubstrat (10) als ein texturiertes Silbersubstrat (12) gewählt wird,
insbesondere wobei das Silbersubstrat (10) eine Oberfläche in einer 001- oder 110-Ausrichtung zu der REBCO-Schicht (45) exponiert.

**16.** Verfahren (100) nach einem der Ansprüche 1 bis 14, **dadurch gekennzeichnet, dass** das Silbersubstrat (10) als ein nicht texturiertes polykristallines Silbersubstrat (11) gewählt wird.

**17.** Verfahren (100) nach einem der vorstehenden Ansprüche,
**dadurch gekennzeichnet, dass** das Silbersubstrat (10) mit einer Dicke $TH_{sub}$, mit 25 μm$\leq TH_{sub}\leq$2,5 mm gewählt wird.

**18.** Verfahren (100) nach einem der vorstehenden Ansprüche,
**dadurch gekennzeichnet, dass** die REBCO-Schicht (45) mit einer Dicke $TH_{inter}$, mit $500\ nm \leq TH_{inter}$, insbesondere mit $1\mu m \leq TH_{inter} \leq 5\mu m$, auf dem Silbersubstrat (10) abgeschieden wird.

19. Verfahren nach einem der vorstehenden Ansprüche, **dadurch gekennzeichnet,**

    **dass** während Schritt c)

    $$5\ MPa \leq p_{Bindung} \leq 50\ MPa,$$

    und/oder $750\ °C \leq Temp_{Bindung} \leq 900\ °C$, und/oder der Sauerstoffpartialdruck $OPP_{Bindung}$ eine entsprechende Sauerstoffkonzentration von 10-1000 ppm aufweist, und/oder $1\ min \leq t_{Bindung} \leq 60\ min$, und/oder dass während Schritt d)

    $$300°C \leq Temp_{glühen} \leq 600°C,$$

    und/oder $0{,}5\ bar \leq OPP_{glühen}$, insbesondere wobei eine reine Sauerstoffatmosphäre angewendet wird, und/oder $0h \leq t_{glühen} \leq 10h$.

20. Supraleitende Verbindungsstelle (700) aus Seltenerdbariumkupferoxidbändern, REBCO-Bändern (501, 502),

    die supraleitende Verbindungsstelle (700) umfassend ein erstes REBCO-Basisband (501), das einen ersten Endbereich (561) aufweist, ein zweites REBCO-Basisband (502), das einen zweiten Endbereich (562) aufweist, und ein Brückenbandelement (50), das Brückenbandelement (50) umfassend ein Substrat und eine REBCO-Schicht (45), die sich auf dem Substrat befindet, wobei die REBCO-Schicht (45) eine REBCO-Schicht (45) ist, die durch einen Prozess mit chemischer Lösungsabscheidung, CSD, auf dem Substrat, das ein Silbersubstrat (10) ist, abgeschieden ist, wobei das Silbersubstrat (10) aus Silber oder einer Silberlegierung, die mindestens 75 Gewichts% Silber enthält, besteht, das erste REBCO-Basisband (501) und das zweite REBCO-Basisband (502) jeweils umfassend mindestens ein Basismetallsubstrat (510), eine REBCO-Basisschicht (540), die sich auf dem Basismetallsubstrat (510) befindet, und eine Stabilisierungsschicht (550), die sich auf der REBCO-Basisschicht (540) befindet, wobei in dem ersten Endbereich (561) und dem zweiten Endbereich (562) das erste REBCO-Band (501) und das zweite REBCO-Band (502) frei von der Stabilisierungsschicht (550) sind, und wobei zusätzliche REBCO-Schichten (571, 572) durch einen weiteren CSD-Prozess auf der REBCO-Basisschicht (540) in dem ersten Endbereich (561) und in dem zweiten Endbereich (562) abgeschieden sind, und wobei sich in dem ersten Endbereich (561) das Brückenbandelement (50) mit dem ersten REBCO-Basisband (501) überlappt und sich in dem zweiten Endbereich (562) das Brückenbandelement (50) mit dem zweiten REBCO-Basisband (502) überlappt, wobei die REBCO-Schicht (45) des Brückenbandelements (50) und die REBCO-Basisschichten (540) des ersten REBCO-Basisbandes (501) und des zweiten REBCO-Basisbandes (502) einander zugewandt und miteinander verbunden sind, wobei sich die zusätzlichen REBCO-Schichten (571, 572) einerseits und die REBCO-Schicht (45) des Brückenbandelements (50) andererseits einander zugewandt sind und einander berühren, insbesondere wobei die supraleitende Verbindungsstelle (700) aus REBCO-Bändern (501, 502) durch ein Verfahren nach einem der Ansprüche 1 bis 19 hergestellt ist.

21. Verwendung einer supraleitenden Verbindungsstelle (700) aus REBCO-Bändern (501, 502) nach Anspruch 20 oder hergestellt nach einem der Ansprüche 1 bis 19, in einem supraleitenden Magneten eines NMR-Spektrometers oder MRT-Tomografen, insbesondere wobei der supraleitende Magnet im persistenten Modus betrieben wird.

**Revendications**

1. Procédé pour fabriquer un joint supraconducteur (700) de rubans en oxyde de cuivre, de baryum et des terres rares, REBCO, (501, 502) au moyen des étapes suivantes :

   étape a) (610) au niveau d'un premier ruban de base en REBCO (501) qui comprend au moins un substrat en métal de base (510), une couche en REBCO de base (540) localisée sur le substrat en métal de base (510) et une couche de stabilisation (550) localisée sur la couche en REBCO de base (540), la couche de stabilisation (550) est enlevée dans une première région d'extrémité (561) ; et au niveau d'un second ruban de base en REBCO (502) qui comprend au moins un substrat en métal de base (510), une couche en REBCO de base (540) localisée sur le substrat en métal de base (510) et une couche de stabilisation (550) localisée sur la couche en REBCO de base (540), la couche de stabilisation (550) est enlevée dans une seconde région d'extrémité (562) ; et un élément de ruban à fonction de pont (50) est fabriqué par dépôt d'une couche en REBCO (45) au moyen d'un processus de dépôt par solution chimique, CSD, sur un substrat qui est un substrat en argent (10), dans lequel le substrat en argent (10) est réalisé à partir d'argent ou d'un alliage d'argent qui contient au moins 75 % en poids d'argent, dans lequel le processus CSD inclut :

- au moins une étape de dépôt (110), étape au cours de laquelle une solution de précurseur de REBCO est déposée sur le substrat en argent (10), ce qui conduit à une couche de précurseur de REBCO du type gel (20) ;

la solution de précurseur de REBCO comprenant un solvant et des sels de précurseur de REBCO dissous qui incluent une teneur organique ; et
la couche de précurseur de REBCO du type gel (20) contenant un mélange amorphe de composants de REBCO qui incluent une teneur organique ;

- au moins une étape de pyrolyse (120), étape au cours de laquelle la couche de précurseur de REBCO du type gel (20) est soumise à pyrolyse lors d'un traitement thermique de premier niveau, ce qui conduit à une couche de composants de REBCO amorphe (30) ;

la couche de composants de REBCO amorphe (30) contenant un mélange amorphe de composants de REBCO et étant exempte de teneur organique ;

- au moins une étape de transformation (130), étape au cours de laquelle au moins une couche de composants de REBCO amorphe (30) est transformée lors d'un traitement thermique de second niveau, ce qui conduit à une couche en matériau de REBCO (40),

la couche en matériau de REBCO (40) contenant du REBCO polycristallin ou texturé ;
étape a') (615) des couches en REBCO auxiliaires respectives (571, 572) sont déposées au moyen d'un autre processus CSD sur les couches en REBCO de base (540) du premier ruban de base en REBCO (501) dans la première région d'extrémité (561) et du second ruban de base en REBCO (502) dans la seconde région d'extrémité (562) ;
étape b) (620) le premier ruban de base en REBCO (501), le second ruban de base en REBCO (502) et l'élément de ruban à fonction de pont (50) sont agencés de telle sorte que, dans la première région d'extrémité (561), l'élément de ruban à fonction de pont (50) chevauche le premier ruban de base en REBCO (501) et entre en contact avec celui-ci et que, dans la seconde région d'extrémité (562), l'élément de ruban à fonction de pont (50) chevauche le second ruban de base en REBCO (502) et entre en contact avec celui-ci, la couche en REBCO (45) de l'élément de ruban à fonction de pont (50) et les couches en REBCO de base (540) du premier ruban de base en REBCO (501) et du second ruban de base en REBCO (502) se faisant mutuellement face ;
étape c) (630) dans la première région d'extrémité (561) et dans la seconde région d'extrémité (562), le premier ruban de base en REBCO (501), le second ruban de base en REBCO (502) et l'élément de ruban à fonction de pont (50) sont pressés ensemble au moyen de l'application d'une pression mécanique $p_{bond}$ pendant un traitement thermique à une température $Temp_{bond}$ en deçà de la température de fusion du substrat en argent (10) dans une atmosphère à teneur faible en oxygène sous une pression partielle d'oxygène $OPP_{bond}$ pendant un temps de liaison $t_{bond}$ ; et
étape d) (640) dans la première région d'extrémité (561) et dans la seconde région d'extrémité (562), le premier ruban de base en REBCO (501), le second ruban de base en REBCO (502) et l'élément de ruban à fonction de pont (50) subissent un traitement thermique à une température $Temp_{anneal}$, moyennant $Temp_{anneal} < Temp_{bond}$, dans une atmosphère à teneur élevée en oxygène sous une pression partielle d'oxygène $OPP_{anneal}$, moyennant $OPP_{anneal} > OPP_{bond}$ pendant un temps de recuit $t_{anneal}$, moyennant $t_{anneal} \geq t_{bond}$,
en particulier, dans lequel, au niveau de l'étape d), aucune pression mécanique n'est désormais appliquée.

2. Procédé (100) selon la revendication 1, **caractérisé en ce que** :

le processus CSD de l'étape a) et/ou l'autre processus CSD de l'étape a') inclu(en)t une pluralité de sous-séquences de pyrolyse (PSS), dans lequel chaque sous-séquence de pyrolyse (PSS) inclut une étape de dépôt (110) qui est suivie par une étape de pyrolyse (120).

3. Procédé (100) selon la revendication 2, **caractérisé en ce que** :

le processus CSD de l'étape a) et/ou l'autre processus CSD de l'étape a') inclu(en)t la réalisation d'une pluralité de sous-séquences de pyrolyse subséquentes (PSS) avant la réalisation d'une étape de transformation suivante (130).

4. Procédé (100) selon la revendication 3, **caractérisé en ce que** :

le processus CSD de l'étape a) et/ou l'autre processus CSD de l'étape a') inclu(en)t la réalisation d'une étape de transformation commune (130),

dans lequel toutes les couches en composants de REBCO amorphes (30) qui sont obtenues au niveau de toutes les étapes de pyrolyse (120) sont transformées en commun.

5. Procédé (100) selon la revendication 2, **caractérisé en ce que** :

le processus CSD de l'étape a) et/ou l'autre processus CSD de l'étape a') inclu(en)t une pluralité de sous-séquences de transformation subséquentes (TSS),

dans lequel chaque sous-séquence de transformation (TSS) inclut au moins une sous-séquence de pyrolyse (PSS) qui est suivie par une étape de transformation (130).

6. Procédé (100) selon la revendication 5, **caractérisé en ce qu'**au moins une sous-séquence de transformation (TSS), de préférence chaque sous-séquence de transformation (TSS), comprend seulement une sous-séquence de pyrolyse (PSS).

7. Procédé (100) selon la revendication 5 ou 6, **caractérisé en ce qu'**au moins une sous-séquence de transformation (TSS), de préférence chaque sous-séquence de transformation (TSS), comprend une pluralité de sous-séquences de pyrolyse subséquentes (PSS).

8. Procédé (100) selon l'une quelconque des revendications précédentes, **caractérisé en ce qu'**au moins un traitement thermique de premier niveau, en particulier chaque traitement thermique de premier niveau, inclut un temps d'arrêt à une température $Temp_{pyro}$, moyennant 300 °C $\leq Temp_{pyro} \leq$ 550 °C pour un temps de pyrolyse $t_{pyro}$, moyennant 10 minutes $\leq t_{pyro} \leq$ 60 minutes.

9. Procédé (100) selon l'une quelconque des revendications précédentes, **caractérisé en ce qu'**au moins un traitement thermique de second niveau, en particulier chaque traitement thermique de second niveau, inclut un temps d'arrêt à une température $Temp_{trans}$, moyennant 750 °C $\leq Temp_{trans} \leq$ 850 °C pour un temps de cristallisation $t_{trans}$, moyennant 5 minutes $\leq tt_{rans} \leq$ 180 minutes.

10. Procédé (100) selon l'une quelconque des revendications précédentes, **caractérisé en ce qu'**au moins un traitement thermique de premier niveau, en particulier chaque traitement thermique de premier niveau, est effectué dans une atmosphère d'oxygène pur.

11. Procédé (100) selon l'une quelconque des revendications 1 à 10, **caractérisé en ce qu'**au moins un traitement thermique de second niveau, en particulier chaque traitement thermique de second niveau, est effectué dans une atmosphère qui présente une pression partielle d'oxygène avec une concentration en oxygène correspondante de 10 à 1 000 ppm.

12. Procédé (100) selon l'une quelconque des revendications 1 à 10, **caractérisé en ce qu'**au moins un traitement thermique de second niveau, en particulier chaque traitement thermique de second niveau, est effectué dans une atmosphère d'oxygène pur.

13. Procédé (100) selon l'une quelconque des revendications 1 à 12, **caractérisé en ce que** la couche en REBCO (45) est déposée directement sur le substrat en argent (10).

14. Procédé (100) selon l'une quelconque des revendications 1 à 12, **caractérisé en ce que** le substrat en argent (10) est muni d'une ou de plusieurs couches tampons (13), et la couche en REBCO (45) est déposée sur le sommet des une ou plusieurs couches tampons (13) du substrat en argent (10).

15. Procédé (100) selon l'une quelconque des revendications 1 à 14, **caractérisé en ce que** le substrat en argent (10) est choisi en tant que substrat en argent texturé (12), en particulier le substrat en argent (10) exposant une surface selon une orientation 001 ou 110 à la couche en REBCO (45).

16. Procédé (100) selon l'une quelconque des revendications 1 à 14, **caractérisé en ce que** le substrat en argent (10) est choisi en tant que substrat en argent polycristallin non texturé (11).

17. Procédé (100) selon l'une quelconque des revendications précédentes, **caractérisé en ce que** le substrat en argent (10) est choisi selon une épaisseur $TH_{sub}$, moyennant 25 $\mu$m $\leq TH_{sub} \leq$ 2,5 mm.

18. Procédé (100) selon l'une quelconque des revendications précédentes, **caractérisé en ce que** la couche en REBCO (45) est déposée sur le substrat en argent (10) selon une épaisseur $TH_{inter}$, moyennant 500 nm $\leq TH_{inter}$, en particulier moyennant 1 $\mu$m $\leq TH_{inter} \leq 5$ $\mu$m.

19. Procédé selon l'une quelconque des revendications précédentes, **caractérisé en ce que** :
pendant l'étape c),

$$5 \text{ MPa} \leq p_{bond} \leq 50 \text{ MPa},$$

et/ou 750 °C $\leq Temp_{bond} \leq 900$ °C,
et/ou la pression partielle d'oxygène $OPP_{bond}$ présente une concentration en oxygène correspondante de 10 à 1 000 ppm,
et/ou 1 minute $\leq t_{bond} \leq 60$ minutes,
et/ou **en ce que** :

pendant l'étape d),

$$300 \text{ °C} \leq Temp_{anneal} \leq 600 \text{ °C},$$

et/ou 0,5 bar $\leq OPP_{anneal}$,
en particulier dans lequel une atmosphère d'oxygène pur est appliquée,
et/ou a h $\leq tanneal \leq 10$ h.

20. Joint supraconducteur (700) de rubans en oxyde de cuivre, de baryum et des terres rares, REBCO, (501, 502),

le joint supraconducteur (700) comprenant un premier ruban de base en REBCO (501) qui comporte une première région d'extrémité (561), un second ruban de base en REBCO (502) qui comporte une seconde région d'extrémité (562) et un élément de ruban à fonction de pont (50), l'élément de ruban à fonction de pont (50) comprenant un substrat et une couche en REBCO (45) localisée sur le substrat, dans lequel la couche en REBCO (45) est une couche en REBCO (45) qui est déposée au moyen d'un processus de dépôt par solution chimique, CSD, sur le substrat qui est un substrat en argent (10), dans lequel le substrat en argent (10) est réalisé à partir d'argent ou d'un alliage d'argent qui contient au moins 75 % en poids d'argent ; et le premier ruban de base en REBCO (501) et le second ruban de base en REBCO (502) comprenant chacun au moins un substrat en métal de base (510), une couche en REBCO de base (540) localisée sur le substrat en métal de base (510) et une couche de stabilisation (550) localisée sur la couche en REBCO de base (540) ;
dans lequel, dans la première région d'extrémité (561) et dans la seconde région d'extrémité (562), le premier ruban en REBCO (501) et le second ruban en REBCO (502) sont exempts de la couche de stabilisation (550) ; et
dans lequel des couches en REBCO auxiliaires (571, 572) sont déposées au moyen d'un autre processus CSD sur la couche en REBCO de base (540) dans la première région d'extrémité (561) et dans la seconde région d'extrémité (562) ; et
dans lequel, dans la première région d'extrémité (561), l'élément de ruban à fonction de pont (50) chevauche le premier ruban de base en REBCO (501) et dans la seconde région d'extrémité (562), l'élément de ruban à fonction de pont (50) chevauche le second ruban de base en REBCO (502), la couche en REBCO (45) de l'élément de ruban à fonction de pont (50) et les couches en REBCO de base (540) du premier ruban de base en REBCO (501) et du second ruban de base en REBCO (502) se faisant mutuellement face et étant mutuellement connectées, les couches en REBCO auxiliaires (571, 572) d'une part et la couche en REBCO (45) de l'élément de ruban à fonction de pont (50) d'autre part se faisant face mutuellement et étant en contact mutuel,
en particulier, dans lequel le joint supraconducteur (700) de rubans en REBCO (501, 502) est fabriqué au moyen d'un procédé selon l'une quelconque des revendications 1 à 19.

21. Utilisation d'un joint supraconducteur (700) de rubans en REBCO (501, 502) selon la revendication 20 ou fabriqué selon l'une quelconque des revendications 1 à 19, dans un aimant supraconducteur d'un spectromètre RMN ou d'un tomographe IRM, en particulier dans lequel l'aimant supraconducteur est activé dans un mode persistant.

100

Fig. 1

```
                    ┌─────────────┐
                    │     80      │
                    │    start    │
                    └─────────────┘
                           │
                           ▼
                    ┌─────────────┐
                    │     90      │
                    │  substrate  │
                    │ preparation │
                    └─────────────┘
```

PSS

TSS

```
                    ┌─────────────┐
                    │    110      │
                    │ deposition  │
                    └─────────────┘
                           │
                           ▼
                    ┌─────────────┐
                    │    120      │
                    │  pyrolysis  │
                    └─────────────┘
```

$R_{TSS}$

$R_{PSS}$

$\text{Temp}_{pyro}$   $t_{pyro}$   $\text{OPP}_{pyro}$

```
                    ┌─────────────┐
                    │    130      │
                    │transformation│
                    └─────────────┘
```

$\text{Temp}_{trans}$   $t_{trans}$   $\text{OPP}_{trans}$

with $\text{Temp}_{trans} > \text{Temp}_{pyro}$

```
                    ┌─────────────┐
                    │140 finished │
                    │ bridge tape │
                    │   element   │
                    └─────────────┘
```

Fig. 2

Fig. 3

Fig. 4

Fig. 5

Fig. 6

Fig. 7

Fig. 8

Fig. 9a

Fig. 9b

Fig. 9c

Fig. 9d

$Temp_{bond}$

$OPP_{bond}$

Fig. 9e

$Temp_{anneal}$

$Temp_{anneal} < Temp_{bond}$

$OPP_{anneal}$

$OPP_{anneal} > OPP_{bond}$

Fig. 10

Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2565839 A
- EP 2741370 A1
- US 10333050 B
- JP 2021068583 A

**Non-patent literature cited in the description**

- **KATAYAMA S et al.** Highly oriented YBa2Cu4O8 films fabricated at atmospheric pressure by the sol-gel method using metal alkoxides. *APPLIED PHYSICS LETTERS*, 06 January 1992, vol. 60 (1), 118-119
- **MASUDA Y et al.** Production of YBa2Cu3O7-x thick films on Ag metal substrate controlled by oxygen. *JAPANESE JOURNAL OF APPLIED PHYSICS*, 01 September 1992, vol. 31 (9A), 2709-2715
- **LIU M et al.** Fabrication of YBCO Films on and Textured Ag Substrates by TFA-MOD Method. *IEEE TRANSACTIONS ON APPLIED SUPERCONDUCTIVITY*, 01 June 2007, vol. 17 (2), 3601-3604
- **OBRADORS X et al.** Progress towards all-chemical superconducting YBa2Cu3O7-coated conductors. *SUPERCONDUCTOR SCIENCE AND TECHNOLOGY*, 20 January 2006, vol. 19 (3), S13-S26
- **AMEMIYA I et al.** Preparation of Y-Ba-Cu-O superconducting tape by pyrolysis of organic acid salts. *IEEE TRANSCACTIONS ON MAGNETICS*, 01 March 1991, vol. 27 (2), 905-908
- **HUANG D et al.** Achievement of Low-Resistivity Diffusion Joint of REBCO Coated Conductors by Improving the Interface Connection of Ag Stabilizer. *IEEE TRANSACTIONS ON APPLIED SUPERCONDUCTIVITY*, 08 January 2021, vol. 31 (3)